# EUROPÄISCHE PATENTSCHRIFT

(11) **EP 1 620 492 B1**
(45) Veröffentlichungstag und Bekanntmachung des Hinweises auf die Patenterteilung: **25.03.2009**
(21) Anmeldenummer: 04731627.8
(22) Anmeldetag: 07.05.2004
(51) Int. Cl.: C08G 79/00, C08G 79/08, C08G 83/00, C08G 77/56, H01L 51/00

(54) **NICHT KONJUGIERTE POLYMERE PERARYLIERTE BORANE, DEREN VERWENDUNG ALS ORGANISCH HALBLEITENDE EMITTER UND/ODER TRANSPORTMATERIALIEN, VERFAHREN ZU DEREN HERSTELLUNG UND ANWENDUNGEN DAVON**
NON-CONJUGATED POLYMERIC PERARYLATED BORANES, USE THEREOF AS ORGANICALLY SEMICONDUCTING TRANSMITTERS AND/OR TRANSPORT MATERIALS, METHODS FOR PRODUCING SAME AND USES THEREOF
BORANES PERARYLES POLYMERIQUES NON CONJUGUES, LEUR UTILISATION COMME EMETTEURS ET/OU MATERIAUX DE TRANSPORT ORGANIQUEMENT SEMI-CONDUCTEURS, LEUR PROCEDE DE PRODUCTION ET LEURS UTILISATIONS

(30) Priorität: 08.05.2003 DE 10320713; 13.01.2004 DE 102004001865
(43) Veröffentlichungstag der Anmeldung: 01.02.2006
(73) Patentinhaber: OSRAM Opto Semiconductors GmbH, 93055 Regensburg (DE)
(72) Erfinder: KANITZ, Andreas, 91315 Höchstadt (DE); ROGLER, Wolfgang, 91096 Möhrendorf (DE); WOERLE, Jasmin, 90763 Fürth (DE)
(74) Vertreter: Epping - Hermann - Fischer
(86) Internationale Anmeldenummer: PCT/EP2004/004901
(87) Internationale Veröffentlichungsnummer: WO 2004/099291

(56) Entgegenhaltungen:
- US-A- 3 213 136
- US-A- 6 057 078

## Beschreibung

Die Erfindung betrifft luminophore Verbindungen mit halbleitenden Eigenschaften sowie deren Herstellung und ihre Anwendung in organischen Leuchtdioden (OLEDS), organischen Solarzellen, organischen Photodetektoren und organischen Feldeffekttransistoren.

Bekannt sind sogenannte "small molecules" (also Einzelmoleküle mit luminophoren Eigenschaften für OLED-Anwendungen) mit perarylierten Boranstrukturen beispielsweise aus der Veröffentlichung von M. Kinoshita et al. "A Novel Family of Boron-Containing Hole-Blocking Amorphous Molecular Materials for Blue- and Blue-Violet-Emitting Organic Electroluminescence Devices", Advanced Functional Materials 2002, 12, No. 11-12, Dezember, Seite 780 - 786".
Nachteilig an den small molecules ist, dass sie schlecht applizierbar sind, weil sich Einzelmoleküle als OLED-Schichten nicht durch spin coating oder andere Beschichtungsmethoden wie Druckprozesse herstellen lassen, sondern kostspielige Aufbringungsmethoden wie Aufdampfprozesse erfordern.

Aufgabe der Erfindung ist es, neue organische, polymere halbleitende Emitter- und Transportmaterialien zu schaffen, die in organischen elektronischen und/oder mit halbleitenden Materialien ausgestatteten Geräten eingesetzt werden können und die präperativ gut zugänglich, insbesondere in Massenfertigungsprozessen verarbeitbar sind.

Gegenstand der Erfindung sind Polyarylborane des Typs **K**, 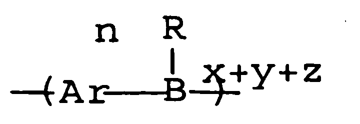 wobei Folgendes gilt:
**x,y** und **z** sind molare Teile von Komponenten und ergeben in Summe gleich 1, wobei zwei der Indizes **x,y** und **z** auch den Wert 0 haben können,
an den Enden sind Wasserstoff-Atome gebunden,
**Arⁿ** steht für die jeweilige Arylenkomponente, **-Ar¹-** und/oder - **Ar²-** und/oder **-Ar³-** im Copolymer, wobei die Copolyarylborane des Typs K eine Arylenkomponente **-Ar³-** enthalten,
dabei stehen **Ar¹** und **Ar²** für Komponenten mit einer bivalent konjugativ verbindenden ein- oder mehrkernigen, aromatischen und/oder heteroaromatischen Arylenstruktur, wobei **Ar¹** für eine Komponente steht, deren π-Elektronendichte gleich oder größer als die von Benzol ist und **Ar²** für eine Komponente, die lochtransportfähig ist,
**Ar³** steht für eine Komponente, die ausgewählt ist aus den in Tabelle 3 gezeigten Verbindungen der Typen Ar³ (a-m) und weist eine geringere π-Elektronendichte, die gleich oder kleiner als die des Benzols ist, auf,
wobei die π-Elektronendichte von **Ar³** in jedem Fall kleiner als die von **Ar¹** ist,
und
**R** steht für einen Rest mit Arylstruktur, der je nach beabsichtigter Konjugation des Polyborans K einen heteroaromatischen und/oder einen (homo)-aromatischen Arylrest umfasst,
   - der donorfrei ist, wobei eine Konjugation im Polyboran **K** durch Anlegen eines elektrischen Feldes ausgebildet werden kann, und/oder
   - bei dem mindestens eine zusätzliche Donorfunktion substituiert ist (intrinsische Konjugationsausbildung) und/oder
   - dessen Wasserstoffatome auch beliebig durch einen oder mehrere verzweigte oder unverzweigte Alkylreste oder Alkoxyreste **R*,** substituiert sein können.
      Weiterhin ist Gegenstand der Erfindung ein Verfahren zur Herstellung der Polyarylborane des Typs **K** nach dem allgemeinen Herstellungsschema

### Reaktionsschema:

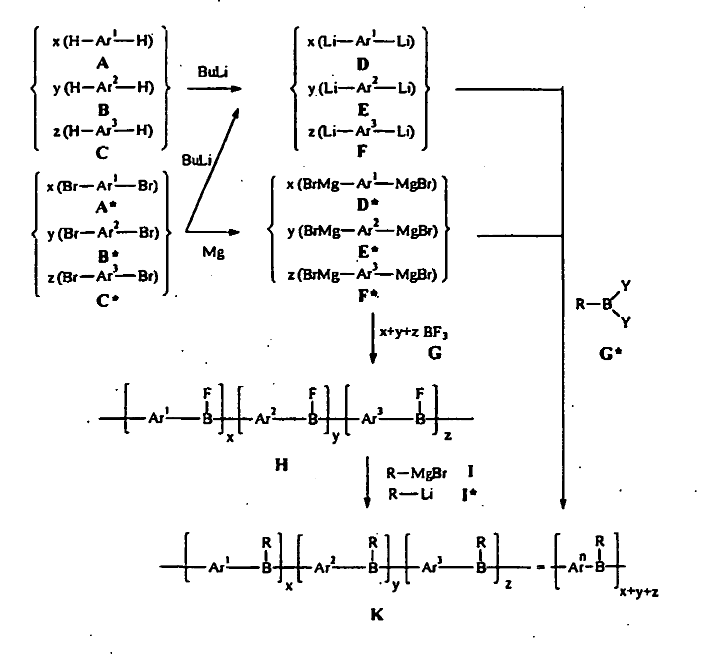

wobei von den Arenen **A** bis **C** bzw. von den bromsubstituierten Arylenstrukturen **A*** bis **C*** ausgegangen wird, diese werden entweder durch eine Grignardreaktion (**D*** bis **F***) oder durch Lithiierung (**D** bis **F**) umgepolt (siehe Schema). Darauffolgend können zwei grundsätzliche Reaktionswege zur Bildung der Copolyborane **K** genutzt werden. Entweder werden die metallierten Verbindungen mittels Bortrifluorid **G** in Fluoroco-polyboran-produkte **H** überführt und diese ohne Aufarbeitung wiederum mittels eines Grignard-reagenzes **I** oder eines lithiierten Reagenzes **I*** (siehe Schema) zu Co-polyboranen **K** in thermodynamisch getriebenen Substitutionsreationen unter Bildung von Alkali- bzw. Erdalkalibromiden umgesetzt oder die metallierten Verbindungen werden in einem Schritt mittels einer Arylborverbindung **G*** direkt zu den Co-polyboranen **K** umgesetzt, wobei **Y** (siehe Schema) für zwei Halogenid-, zwei Alkoxy- oder eine Dioxyalkylen-struktur (mit 1 bis 3 C-Atomen) steht.

Schließlich ist Gegenstand der Erfindung die Verwendung der Polyarylborane des Typs **K** in organischen halbleitenden Elementen wie Leuchtdioden und/oder Leuchtdiodendisplays, je nach ihrer Zusammensetzung,
- als emittierende Schicht in verschiedenen Farben und weiss,
- als Elektronen transportierende Schicht und/oder
- als Löcher blockierende Schicht
- und/oder mit einem Überschuß an Komponenten des Typs **Ar²** als lochtransportierende Schicht
   sowie als maßgeschneidertes Transportmaterial in den Funktionsschichten organischer Solarzellen, organischer Photodetektoren und organischer Feldeffekttransistoren.

Gegenstand der Erfindung ist darüber hinaus auch die Verwendung der Polyarylborane **K** als Blends von Einzelkomponentenpolymeren, also für den Fall, dass zwei der Verhältnisvariablen x, y und/oder z (Strukturformel Typ **K**) den Wert Null haben.

Ausserdem ist noch die Verwendung der polymeren Einzelkomponenten als Material für eine elektrolumineszierende Schicht und/oder organische Halbleiterschicht also Elektronen transportierend, Löcher blockierend oder Löcher transportierend Gegenstand der Erfindung.

**Arⁿ** steht für die jeweilige Arylenkomponenten **-Ar¹-** und/oder - **Ar²-** und/oder **-Ar³-** im Copolymer,
bevorzugt eine, bei der die Umgebung des Boratoms abgeschirmt ist (Typen **K*, K**, K*****), insbesondere dadurch, dass eine oder beide ortho-Stellungen der Bor-Kohlenstoff-Bindungen der jeweiligen Arylenkomponenten **Arⁿ** und der Arylsubstituenten **R** beispielsweise mit Methylsubstituenten ausgestattet sind, wie beispielweise bei den bis-o,o'-dimethyl-substituierten Arylen-**Arⁿ** oder Arylkomponenten **R** mit Durolderivaten als , Substituenten, wobei die Löslichkeit aller Einzelkomponenten in organischen Lösungsmitteln durch beliebige Anordnung einer oder mehrerer unverzweigter und/oder verzweigter Alkyl- oder Akloxysubstituenten **R*** verbessert sein kann;
unter dem Begriff Aryl- bzw. Arylenkomponente soll ein konjugiertes System von mindestens einer cyclischen Teilstruktur verstanden werden, die im Falle von mehreren cyclischen Teilstrukturen auch von Vinyleneinheiten unterbrochen sein können, wobei die cyclischen Teilstrukturen aromatischer Natur sind, d.h. aus Kohlenstoff oder aus Kohlenstoff und anderen Elementen bestehenden Ringen erzeugt werden, deren Anzahl von π-Elektronen (4n+2) entspricht (n ist ein Parameter der die Zahlen 0 bis 5 annehmen kann) und deren sonstige π-Bindungen bis auf eine, im Falle der monovalenten Arylstruktur, bzw. zwei, im Falle der bivalenten Arylenstruktur mit Wasserstoff und/oder beliebigen sonstigen Substituenten verknüpft sind; 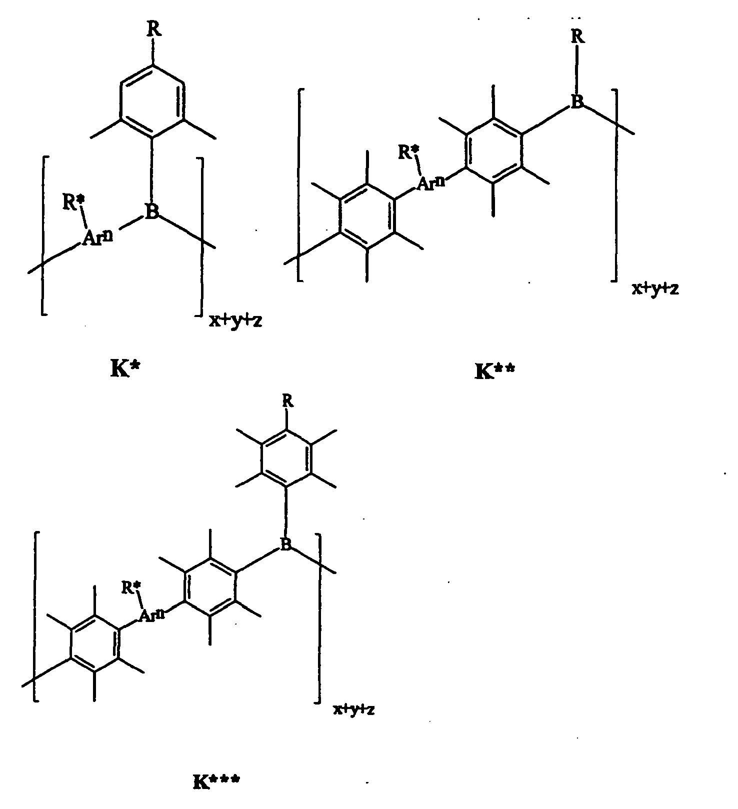 dabei hat **Ar¹** eine Arylenstruktur, bevorzugt die 2,7-Fluorenylenstruktur, die in 9-Position leicht durch unverzweigte und/oder verzweigte Alkylreste, insbesondere bevorzugt mit 1 bis 10 Kohlenstoffatomen, substituiert werden kann, wobei unter dem Begriff Arylenstruktur eine beliebige bivalent konjugativ verbindende ein- oder mehrkernige aromatische oder heteroaromatische Struktur verstanden wird, deren π-Elektronendichte gleich oder größer als die von Benzol ist, wie beispielsweise in Tabelle 1 **Ar¹(a-h)** angegeben,

**Tabelle 1**

| 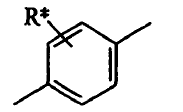 | 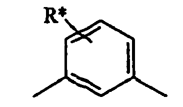 | 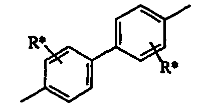 |
|---|---|---|
| **Ar¹(a1)** 1,4-phenylen | **Ar¹(a2)** 1,3-phenylen | **Ar¹(b1)**1,1'-(4,4'-biphenylen) |
| 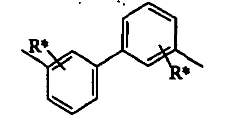 | 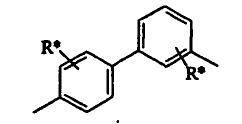 | 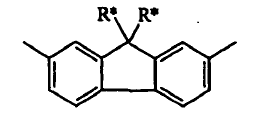 |
| **Ar¹(b2)** 1,1'-(3,3'-biphenylen) | **Ar¹(b3)** 1,1'-(3,4'-biphenylen) | **Ar¹(c)** 2,7-fluorenylen |
| 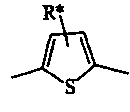 | 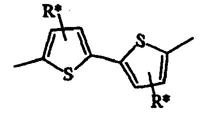 | 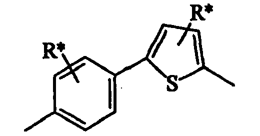 |
| **Ar¹(d)** 2,5-thienylen | **Ar¹(e)** 2,2'-(5,5'-bis-thienylen) | **Ar¹(f1)** 4',5-(2-phenylthienylen) |
| 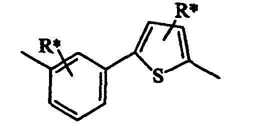 | 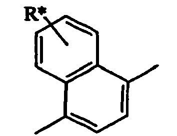 | 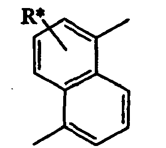 |
| **Ar¹(f2)** 3',5-(2-phenylthienylen) | **Ar¹(g1)** 1,4-naphthylen | **Ar¹(g2)** 1,5-naphthylen |
| 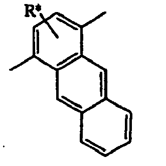 | 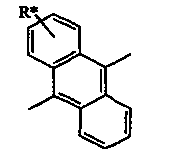 | 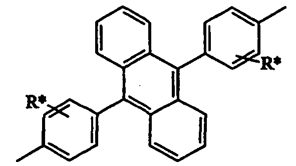 |
| **Ar¹(b1)** 1,4-anthrylen | **Ar¹(b2)** 9,10-anthrylen | **Ar¹(h3)** 4',4'-bis-(9, 10-diphenyl) -anthrylen |

deren Löslichkeit in organischen Lösungsmitteln durch zusätzliche und beliebige Anordnung von einem oder mehreren, unverzweigten und/oder verzweigten, bevorzugt orthoständig zum Boratom angeordneten Alkylsubstituenten und/oder Alkoxysubstituenten, mit insbesondere bevorzugt mit 1 bis 10 Kohlenstoffatomen **R*** verbessert werden kann;
**Ar²** hat eine lochtransportfähige Arylenstruktur, wobei unter dem Begriff lochtransportfähige Arylenstruktur eine beliebige bivalent konjugativ verbindende ein- oder mehrkernige aromatische und/oder heteroaromatische Struktur verstanden wird, die über zusätzliche konjugativ verknüpfte perarylierte Aminsubstituenten verfügt, wie beispielsweise in Tabelle 2 **Ar²(a-f)** angegeben ist,

**Tabelle 2**

| |
|---|
| 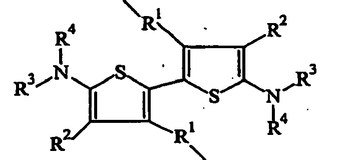 |
| **Ar² (a)** [bis-(2,2'diarylamino-3,3'-diaryl-5,5'thien)]-4,4'-ylen |
| 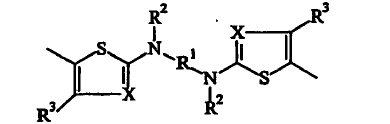 |
| **Ar²(b)** [N,N'-bis-(thien-2-yl)- bzw. N,N'-bis-(1,3-thiazol-2-yl)-N,N'-diaryl-diaminoarylen]-5,5'-ylen |
| 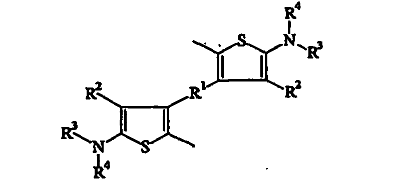 |
| **Ar²(c)** [bis-(2,2'-diarylamino)-3,3'-diaryl-4,4'-thienyl)-arylen]-5,5'-ylen |
| 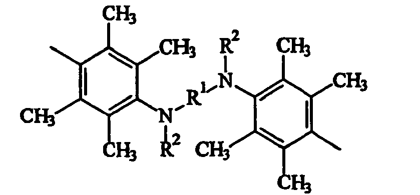 |
| **Ar²(d)** [N,N'-bis-(3-duryl)-N,N'-diaryl-diaminoarylen]-6,6'-ylen |
| 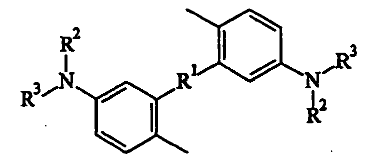 |
| **Ar²(e)** Bis-[(5,5'-diarylamino-phenyl)-arylen]-2,2'-ylen |
| 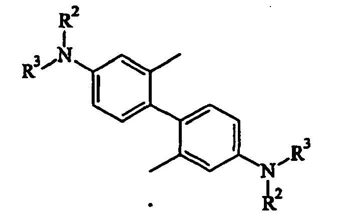 |
| **Ar²(f)** bis-(4,4'-diarylamino-phenyl)2,2'-ylen |

wobei die Substituenten **R², R³** und **R⁴** Arylsubstituenten sind, bevorzugt Phenyl, 1-Naphthyl, 2-Naphthyl, deren Löslichkeit durch zusätzliche und beliebige Anordnung von einem oder mehreren unverzweigten und/oder verzweigten, bevorzugt orthoständig zum Boratom angeordneten Alkylsubstituenten und/oder Alkoxysubstituenten, insbesondere bevorzugt mit 1 bis 10 Kohlenstoffatomen, in organischen Lösungsmitteln verbessert werden kann, dabei sind die Bedeutungen der Substituenten **Rⁿ** mit gleichem Index **n** identisch und/oder die Bedeutung der Substituenten **R¹** gleichbedeutend mit der Substituentenauswahl für die Arylenkomponente **Ar¹,** bevorzugt 9,9-Dialkyl-2,7-fluorenylen **Ar¹(c)-Typ** oder 3,6-Durylen **Ar¹(a)-Typ;**
für **Ar²(b)** gilt außerdem, dass **X** gleich N oder **C-R⁴** ist;
**Ar³** hat eine Arylenstruktur mit geringer π-Elektronendichte, wobei unter dem Begriff Arylenstruktur mit geringer π-Elektronendichte eine beliebige bivalent konjugativ verbindende ein- oder mehrkernige heteroaromatische Struktur verstanden wird, deren π-Elektronendichte gleich oder kleiner als die des Benzols ist, wie beispielsweise in Tabelle 3
**Ar³(a-m)** angegeben ist,

**Tabelle3**

| | |
|---|---|
| 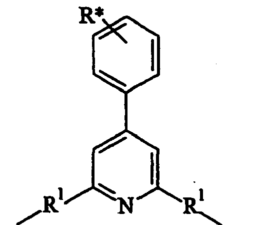 | 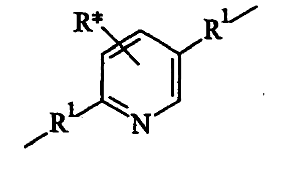 |
| **Ar³(a1)** 2,6-(Diarylen)-pyridinylene | **Ar³(a2)** 2,5-(diarylen)-pyridinylene |
| 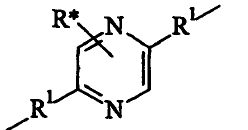 | 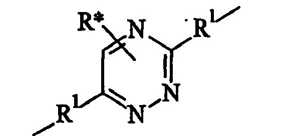 |
| **Ar³(b)** 2,5-(Diarylen)-pyrazinylene | **Ar³(c)** 3,6-(Diarylen)-1,2,4-triazinylene |
| 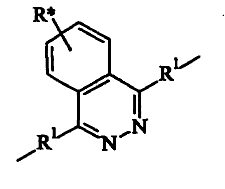 | 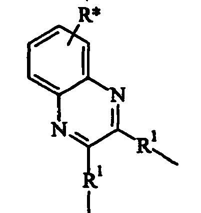 |
| **Ar³(d1)** 1,4-(Diarylen)-phthalazinylene | **Ar³(d2)** 2,3-(Diarylen-chinoxalinylene |
| 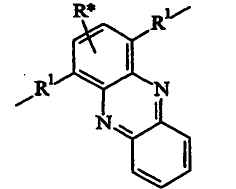 | 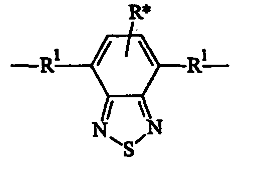 |
| **Ar³(d3)** 1,4-(Diarylen)-phenazinylene | **Ar³(e)** 1,4-(Diarylen)-benzo-thiadiazolylene |
| 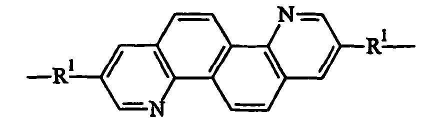 | 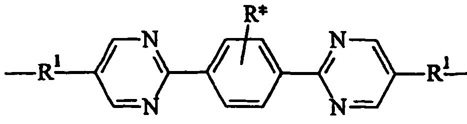 |
| **Ar³(f)** 3,9-(Diarylen)-1,7-diaza-chrysenylene | **Ar³(g1)** Bis-(2,2'-(diarylen)-pyrimidin-5,5'-ylen)-arylene |
| 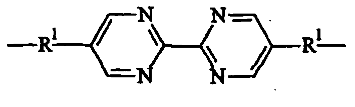 | 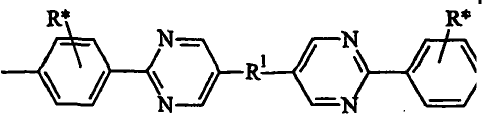 |
| **Ar³(g2)** 2,2'-Pyrimidin-5,5'-(diarylen)-ylene | **Ar³(h)** Bis-[5,5'-(diarylen)-pyrimidin-2,2'-ylen]-arylene |
| 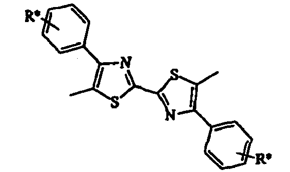 | 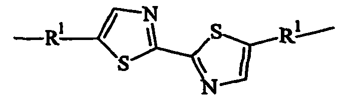 |
| **Ar³(i1)** 2, 2'- (5, 5'-bis-1, 3-thiazolylene) | **Ar³(i2)** 2,2'-(5,5'arylen-bis-1,3-thiazolylene) |
| 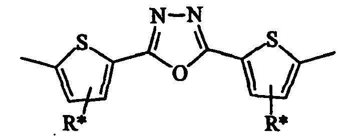 | 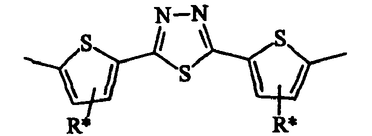 |
| **Ar³(j1)** 5',5'-bis-[2,5-(di-2',2'-thienyl)-oxadiazolylene] | **Ar³(j2)** 5',5'-bis-[2,5-(di-2',2'-thienyl)-thiadiazolylene] |
| 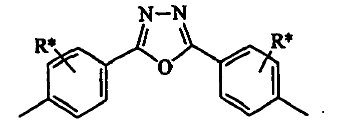 | 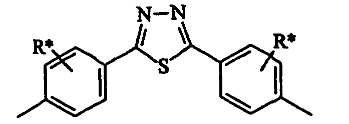 |
| **Ar³(k1)** 4',4'-bis-(2,5-diphenyl-oxadiazolylene) | **Ar³(k2)** 4',4'-bis-(2,5-diphenyl-thiadiazolylene) |
| 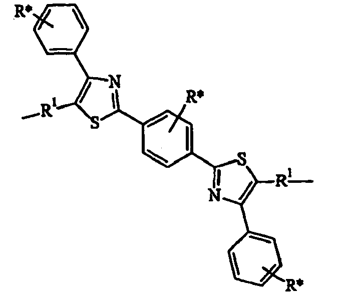 | 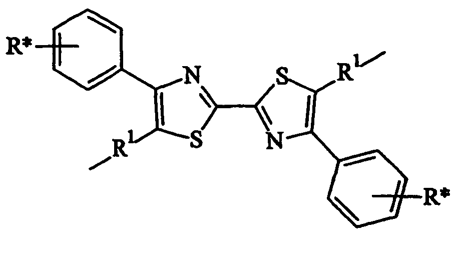 |
| **Ar³(l1)** 2,2'-(5,5'arylen-bis-1,3-thiazolylen)-arylene | **Ar³(l2)** 2,2'-(5,5'arylen-bis-1,3-thiazolylene) |
| 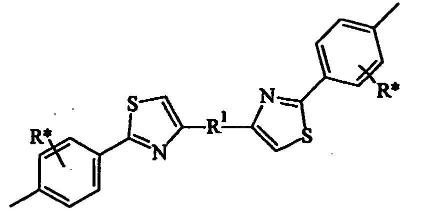 | 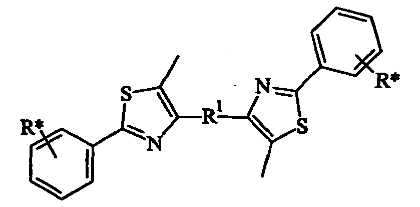 |
| **Ar³(m1)** 4,4'-(2,2'arylen-bis-1,3-thiazolylen)-arylene | **Ar³(m2)** 4,4'-(5,5'ylen-bis-1,3-thiazolylen)-arylene |

deren Löslichkeit in organischen Lösungsmitteln durch zusätzliche beliebige Anordnung von einem oder mehreren, unverzweigten und/oder verzweigten, bevorzugt orthoständig zum Boratom angeordneten Alkylsubstituenten und/oder Alkoxysubstituenten, insbesondere mit 1 bis 10 Kohlenstoffatomen **R*** verbessert werden kann; die Bedeutung der Substituenten **R¹** ist hierbei gleichbedeutend mit der Substituentenauswahl für die Arylenkomponente **Ar¹,** bevorzugt 9,9-Dialkyl-2,7-fluorenylen **Ar¹(c)-Typ** oder 3,6-Durylen **Ar¹(a)-Typ;**
wobei die π-Elektronendichte von **Ar³** in jedem Fall kleiner als die von **Ar¹** ist,
und
**R** steht für einen Rest mit Arylstruktur, der je nach beabsichtigter Konjugation des Polyborans **K** einen heteroaromatischen und/oder einen (homo)-aromatischen Arylrest umfasst, der
- **[R(a1-a5)]** donorfrei ist, wobei eine Konjugation im Polyboran **K** durch Anlegen eines elektrischen Feldes ausgebildet werden kann, und/oder
- **[R(b-e)]** bei dem mindestens eine zusätzliche Donorfunktion substituiert ist (intrinsische Konjugationsausbildung) und/oder
- dessen Wasserstoffatome auch beliebig durch einen oder mehrere verzweigte oder unverzweigte Alkylreste oder Alkoxyreste **R*,** bevorzugt mit 1 bis 10 Kohlenstoffatomen, substituiert sein können;
**R** kann in dem Polyboran **K** im Falle einer intrinsischen Konjugationsausbildung außerdem auch ein N-Carbazoyl-rest **R(f)** sein.
Bevorzugte Arylstrukturen für **R** sind in Tabelle 4 **R(a - f)** angegeben:

**Tabelle 4:**

| | | |
|---|---|---|
| 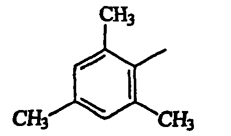 | 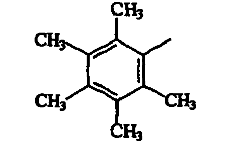 | 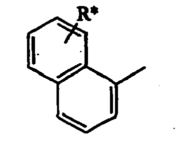 |
| **R(a1)** mesityl | **R(a2)** pentamethylphenyl | **R(a3)** 1-naphthyl |
| 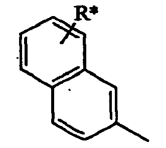 | 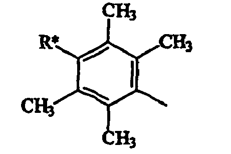 | |
| **R(a4**) 2-naphthyl | **R(a5)** 3-alkyl/alkoxy-dur-6-yl | |
| 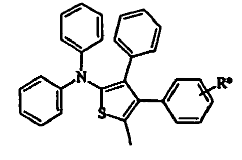 | 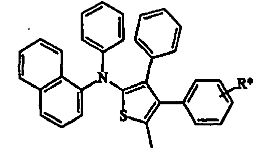 | 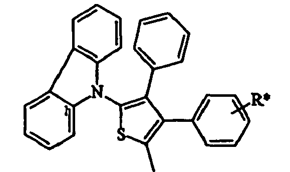 |
| **R(b1)** 2-diphenylamino-3,4-diphenyl-thien-5-yl | **R(b2)** 2-[(1-naphthyl)-phenylamino]-3,4-diphenyl-thien-5-yl | **R(b3**) 2-(N-carbazoyl)-3,4-diphenyl-thien-5-yl |
| 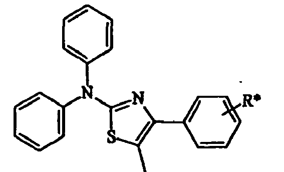 | 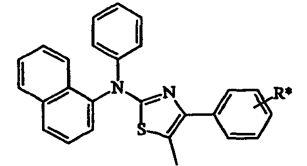 | |
| **R(c1)** 2-diphenylamino-3,4-diphenyl-1,3-thiazol-5-yl | **R(c2)** 2-[(1-naphthyl)-phenylamino]-3,4-diphenyl-1,3-thiazol-5-yl | |
| 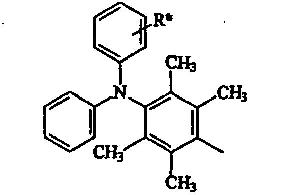 | 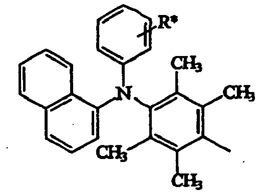 | 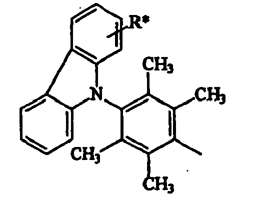 |
| **R(d1)** 3-diphenylamino-dur-6-yl | **R(d2)** 3-[(1-naphthyl)-phenylamino]-dur-6-yl | **R(d3)** 3-(N-carbazoyl)-dur-6-yl. |
| 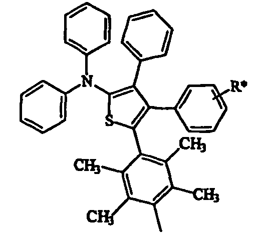 | 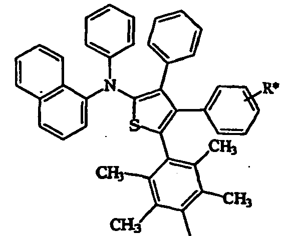 | 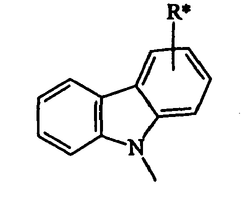 |
| **R(e1)** 2-diphenylamino-3,4- diphenyl-5-(3-dur-6-yl)-thiophen | **R(e2)** 2-[(1-naphthyl)-phenylamino]-3,4-diphenyl-5-(3-dur-6-yl)-thiophen | **R(f)** N-carbazoyl |

**x, y** und **z** (Strukturformel Typ **K**) sind die Verhältniszahlen, die angeben, in welchen Verhältnissen zueinander die polymeren Einzelkomponenten co-polymerisiert werden. Die polymeren Einzelkomponenten können auch jeweils allein als Material für eine elektrolumineszierende Schicht und/oder organische Halbleiterschicht (Elektronen transportierend, Löcher blockierend oder Löcher transportierend) genutzt werden.

**Ar¹** hat eine Arylenstruktur und ist die Arylenkomponente eines bevorzugten Polymermaterials, die als Einzelkomponentenpolyboran im blau bis grünen Spektralbereich emittiert und durch das trivalente, sp²-hybridisierte Bor mit vakantem p-Orbital sehr gute Elektronentransporteigenschaften besitzt; außerdem hat **Ar¹** bevorzugt Substituenten, welche in der Lage sind dem zu bildenden Polymer Löslichkeit zu verleihen.

**Ar²** ist die Arylenkomponente eines weiteren bevorzugten Polymermaterials zur optimalen Einstellung der Lochtransporteigenschaften und zur längerwelligen Emissionskorrektur des Copolymers für die Weissabstimmung und

**Ar³** ist die Arylenkomponente eines weiteren bevorzugten Polymermaterials, das, durch seine geringere π-Elektronendichte blau emittiert und außerdem zum kürzerwelligen Farbabgleich der Emission des Copolymers dient, z.B. zur Einstellung des Weißpunktes. Darüber hinaus enthält das Polymermaterial substituierte Arylengruppierungen, vor allem des Typs **R¹,** zur Verbesserung der Löslichkeit.

Darüber hinaus besteht auch die Möglichkeit Co-polyborane zu synthetisieren die nicht nur aus jeweils einer der Arylenkomponenten **Ar¹** und/oder **Ar²** und/oder **Ar³** bestehen, sondern, es können auch jeweils mehrere Arylenkomponenten der drei Strukturtypen mit einer und/oder mehreren Arylborverbindungen des Typs **G*** copolymerisiert werden.

Allgemeine Beschreibung des Syntheseweges:
Ausgehend von den Ausgangssynthons, den Arylenen **A, B** und **C** bzw. den Dibromarylenderivaten **A*, B*** und **C*,** werden Lithiierungsreaktionen mittels Buthyllithium in Tetrahydrofuran bei -78°C und Grignardreaktionen mit Magnesium in Tetrahydrofuran bei 65°C durchgeführt. Die lithiierten Produkte **D, E** und **F** werden dann einzeln oder in beliebigen gewünschten Verhältnissen in zuerst bei Raumtemperatur und später in der Siedehitze des THF mit Bortrifuoridetherat G so umgesetzt, daß die molare Summe der lithiierten Komponenten der molaren Menge des Borhalogenids entspricht. Dabei führt die Reaktion der bifunktionellen lithiierten Komponenten nur zu einem linearen Co-Polyfluorarylenboran **H.** Co-Polyfluorarylenborane **H** erhält man ebenfalls, wenn man Die Grignardprodukte **D*, E*** und **F*** einzeln oder in beliebigen gewünschten Verhältnissen in der Siedehitze des THF mit Bortrifuoridetherat **G** so umgesetzt, daß die molare Summe der Grignardkomponenten der molaren Menge des Borhalogenids entspricht. Dabei führt die Reaktion der bifunktionellen Grignardkomponenten ebenfalls nur zu einem linearen Co-Polyfluorarylenboran **H.**

Danach synthetisiert man in Analogie zu den bifunktionellen metallierten Verbindungen eine weitere monofunktionelle Grignardkomponente **I** bzw. lithiierte Komponente **I*,** die man nach Austausch des Lösungsmittel THF durch Toluol (nun in der Siedehitze des Toluols) im molaren Verhältnis dem zuvor synthetisieren Co-Polyfluorarylenboran **H** zutropft. Nach 5-stündigem Sieden bei ca. 120°C führt dies zur Substitution des restlichen Fluors durch den Arylrest der Grignardkomponente **I** unter Bildung eines Co-Polyarylboranderivats **K.**

Eine weitere Möglichkeit die Co-Polyarylboranderivate **K** darzustellen bietet sich durch die Substitutionsreaktion aus den lithiierten Verbindungen **A, B** und **C** bzw. aus den Grignardverbindungen **A*, B*** und **C*** und den Arylborsäureestern bzw. Arylborhalogeniden **G*** in stöchiometrischen Verhältnissen. Die Reaktionen werden in THF bei Raumtemperatur beginnend gestartet und innerhalb von 2 Stunden auf Siedetemperatur erhöht, danach wird das Lösungsmittel Tetrahydrofuran durch Toluol destillativ gewechselt und zur Vervollständigung der Reaktion für weitere 4 bis 6 Stunden am Rückfluß erhitzt.

Die Aufarbeitung der Co-polyarylenborane **K**, die nach einem der beiden gezeigten Synthesewegen synthetisiert wurden, erfolgt durch Extraktion der Salze in Wasser und mehrmaliges Fällen der jeweils aufkonzentrierten Polymerlösung in Methanol, wodurch Co-polyarylenborane **K** aufgrund ihrer Komponentenverhältnisse maßgeschneiderte elektrische und optische Eigenschaften besitzen.

Die Erfindung betrifft nicht konjugierte luminophore Verbindungen mit halbleitenden Eigenschaften sowie deren Herstellung und ihre Anwendung in organischen Leuchtdioden (OLEDS), organischen Solarzellen, organischen Photodetektoren und organischen Feldeffekttransistoren. Dabei handelt es sich um Co-polyarylborane des Typs **K**, die erst durch Anlegen eines geeigneten elektrischen Feldes und/oder durch Donorsubstitution des Arylsubstituenten **R** in einen Strukturtyp überführt werden, der sich wie ein konjugiertes Polymer verhält, 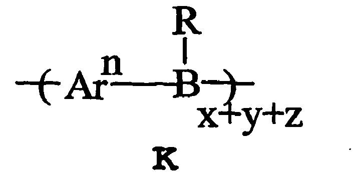 mit den im Anspruch 1 angegebenen Bedeutungen für die Symbole.

### Ausführungsbeispiele:

### Synthese konjugierter, kondensierter und oligo Arylsysteme A

Für den Fall, dass die Arylsysteme **A** nicht kommerziell verfügbar sind, werden sie durch bekannte C-C-Verknüpfungsreaktionen (beispielsweise Suzuki-Kupplung) dargestellt, zuvor werden an mindestens einem Kupplungsbaustein Alkylierungen bzw. Alkoxylierungen durchgeführt, um eine gute Löslichkeit der daraus zu bildenden polymeren Materialien anzustreben.

### Beispiel 1:

### Synthese von 2,7-Di-(2,3,5,6-tetramethyl-phenyl)-9,9-diheptyl-fluoren

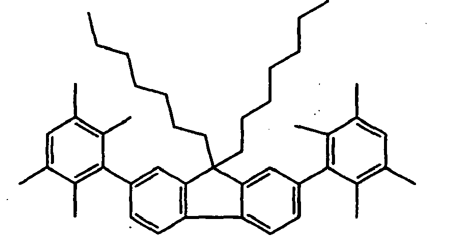

a)Darstellung von 9,9-Diheptyl-fluoren
   0.2 mol Fluoren werden in 300 ml DMSO bei 80°C gelöst. Zur Lösung werden 0.01 mol Phasentransferkatalysator (Aliquot) gegeben und weitere 5 Minuten gerührt. Für die Alkylierung werden 0.5 mol 50%ige Natronlauge und 0.5 mol Heptylbromid benötigt. Die Zugabe erfolgt in drei Stufen, wobei mit der Zugabe von ein Drittel der eingesetzten Menge Natronlauge begonnen wird. Die Lösung verfärbt sich ins Tiefrote und wird nach Zugabe von Heptylbromid langsam gelb. Wenn die Lösung gelb geworden ist, wird das zweite Drittel Natronlauge zugegeben usw. Das Ende der Reaktion wird mittels DC an RP18 in Acetonitril kontrolliert.
   Das Reaktionsgemisch wird dreimal mit Ether und Wasser extrahiert und die organische Phase abgetrennt.
   Nach abdestillieren aller Lösungsmittel (Ether, DMSO, Heptanol) liegt das Produkt als gelbes Öl vor (HPLC-Kontrolle), es wird als Rohprodukt weiterverarbeitet.
b)Darstellung von 2,7-Dibrom-9,9-diheptylfluoren
   0.2 mol Diheptylfluoren werden in 300 ml Chloroform gelöst und zum Sieden erhitzt. In der Dunkelheit werden langsam 0.4 mol Brom, gelöst in Chloroform zugetropft. Die Reaktion wird ca. 12 Stunden in der Siedehitze gerührt. Wenn sich die Reaktionslösung entfärbt hat, ist die Bromierung beendet (DC-Kontrolle an RP 18 in Acetonitril). Nach Erkalten der Lösung wird das gesamte Chloroform abdestilliert und das Produkt in Methanol als weiße Kristalle gefällt. Nach Chromatographie des Produktes an Silicagel in Cyclohexan erhält man HPLCreines Produkt, mp: 45-6°C.
c)Darstellung von Durylboronsäure
   0,2 mol 3-Bromdurol werden in absolutem 800ml THF mittels 0,25 mol Butyllithium unter inerten Bedingungen bei -78°C umgesetzt. Nach Abschluß der BuLi-Zugabe rührt man die Reaktionsmischung noch für 1h bei -78°C und lässt sie danach auftauen. In einem 2l-Kolben werden nun 500ml absoluter Ether und 0,3 mol Borsäuretrimethylester bei -78°C vorgelegt und das zuvor dargestellte Duryllithium in einem Zeitraum von 30 min zugetropft. Man lässt danach auftauen und rührt die Reaktionsmischung noch 12h. Schließlich gießt man das Reaktionsgemisch auf 2n HCl Eismischung und hydrolysiert 12h, extrahiert die organische Phase, engt sie ein und versetzt den Rückstand mit Pentan, wobei das Produkt ausfällt. Man saugt ab und trocknet im Vakuum mp: 101-3°C
d)Darstellung von 2,7-Di-(2,3,5,6-tetramethyl-phenyl)-9,9-diheptyl-fluoren
   0,04 mol Durylboronsäure werden in einem 1-Liter 3-Halskolben mit 600ml Toluol vorgelegt, mit 0,04 mol Propandiol-(1,3) versetzt und am Wasserabscheider erhitzt bis kein Wasser mehr abgeschieden wird. Danach entfernt man den Wasserabscheider, ersetzt ihn durch einen Rückflusskühler und fügt der Reaktionsmischung 0,01 mol 2,7-Dibrom-9,9-diheptyl-fluoren und 11,6 g Pottasche, gelöst in 42 ml Wasser, zu. Nun wird der Kolben mehrfach am Vakuum evakuiert und mit Argon geflutet um den Katalysator, Tetrakis-triphenylphosphin-palladium, zuzugeben. Schließlich wird 48h auf 110°C erhitzt und während dieser Zeit mit Argon gespült. Zur Aufarbeitung wird die organische Phase mehrmals mit Wasser gewaschen, extrahiert und zur Trockene eingeengt. Der Rückstand wird in Methanol gewaschen und abgesaugt. Das Rohprodukt wird durch Chromatographie an Silicagel mittels Cyclohexan gereinigt.
   Kontrolle des Produktes durch HPLC-MS Kopplung, mp: 177-8°C.

### Synthese donorsubstituierter, kondensierter und oligo Arylsysteme B

### Beispiel 2:

### Aufbau der Strukturen Ar²(b)

### a) Synthese arylierter Biscarbonsäureamide

In einem 2 l-Dreihalskolben mit Rückflusskühler, Magnetrührer, Tropftrichter und Inertgasdurchfluss wird jeweils 1 mol eines sekundären arylierten Bisamins in 600 ml Dioxan gelöst. Das jeweils benötigte Carbonsäurehalogenid wird danach in äquivalenter Menge zugetropft. Anschließend wird das Reaktionsgemisch unter Rückfluss erhitzt, bis die gesamte Menge des bei der Reaktion entstehenden Hydrohalogenids vom Inertgasstrom entfernt worden ist. Durch dünnschichtchromatographische Kontrolle kann das Ende der Reaktion zusätzlich detektiert werden. Die Reaktionslösung wird dann abgekühlt und in mindestens die 2-fache Menge Wasser eingerührt. Dabei scheidet sich in den meisten Fällen ein Öl ab, welches nach einigen Stunden erstarrt ist. Die wässrige Phase wird abgetrennt und das Rohprodukt aus Ethanol umkristallisiert. Die Ausbeute beträgt jeweils mindestens 90%.

### aa) N,N'-Di(2-phenylacetyl)-N,N'-diphenyl-phenylen-1,4-diamin

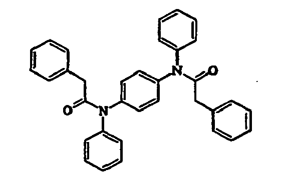

Auf diese Art wird beispielsweise N,N'-Di(2-phenylacetyl)-N,N'-diphenyl-phenylen-1,4-diamin (mp: 190°C) aus N,N'Diphenyl-p-phenylendiamin und 2-Phenylacetylchlorid hergestellt.

### b) Synthese arylierter Bisthiocarbonsäureamide

0,5 mol des jeweiligen arylierten Biscarbonsäureamids und die äquivalente Menge Lawesson-Reagenz (hergestellt aus Anisol und Phosphorpentasulfid) werden in einer Rückflussapparatur mit Inertgasdurchfluss in 750 ml Diglykoldiethylether suspendiert, und dann wird 6 h bei 100°C gerührt. Dabei bildet sich eine klare Lösung, aus der in der Kälte in einigen Fällen das Reaktionsprodukt auskristallisiert. Um das Produkt vollständig zu isolieren, wird die Reaktionsmischung in die doppelte Menge Wasser eingerührt, die sich oft bildende ölige Phase lässt man dann kristallisieren. Danach wird das Produkt von der wässrigen Phase abgetrennt und aus Methanol umkristallisiert. Die Ausbeute beträgt jeweils mindestens 90%.

### ba: N,N'-Di(2-phenylthio-acetyl)-N,N'-diphenyl-phenylen-1,4-diamin

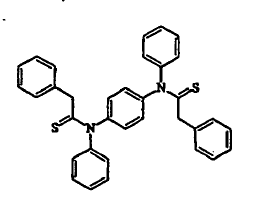

Auf diese Art wird beispielsweise N,N'-Di(2-phenylthioacetyl)-N,N'-diphenyl-phenylen-1,4-diamin (mp: 224 - 227°C) aus N,N'-Di(2-phenylacetyl)-N,N'-diphenyl-phenylen-1,4-diamin und dem Lawesson-Reagenz hergestellt.

### c) Darstellung arylierter Bis-2-aminothiophenderivate

0,2 mol Haloacylarylderivat werden mit 0,1 mol N,N'-Di(2-phenylthio-acetyl)-N,N'-diphenyl-phenylen-1,4-diamin in Tetrahydrofuran vorgelegt und 30 Minuten unter Stickstoffatmosphäre refluxiert. Nach 30 Minuten werden 0,2mol Triethylamin zugegeben und nochmals 30 Minuten refluxiert. Das Produkt wird in Form hellgelber Kristalle in Methanol gefällt.

### ca) N,N'-Diphenyl-N,N'-dithien-3,4-diphenyl-2-yl-phenylen-1,4-diamin

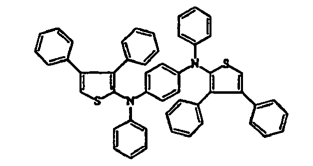

Auf diese Art wird beispielsweise N,N'-Diphenyl-N,N'-dithien-3,4-diphenyl-2-yl-phenylen-1,4-diamin (mp: 266-268°C) aus N,N'-Di(2-phenylthio-acetyl)-N,N'-diphenyl-phenylen-1,4-diamin und Phenacylbromid hergestellt.

### cb) N,N'-Diphenyl-N,N'-dithien-3-phenyl-4-(4-octylphenyl)-2-yl-phenylen-1,4-diamin

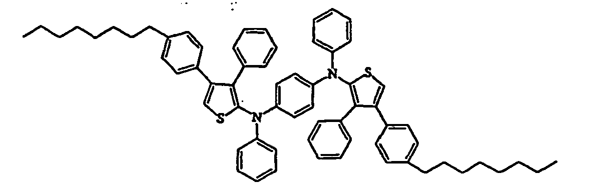

Auf diese Art wird beispielsweise N,N'-Diphenyl-N,N'-dithien-3-phenyl-4-(4-octylphenyl)-2-yl-phenylen-1,4-diamin (mp: 83°C) aus N,N'-Di(2-phenylthio-acetyl)-N,N'-diphenylphenylen-1,4-diamin und Phenacylbromid hergestellt.

### Beispiel 3:

### Aufbau der Strukturen Ar²(c)

### a) Synthese arylierter Carbonsäureamide

In einem 2 1-Dreihalskolben mit Rückflusskühler, Magnetrührer, Tropftrichter und Inertgasdurchfluss wird jeweils 1 mol eines sekundären Diarylamins in 600 ml Dioxan gelöst. Das jeweils benötigte Carbonsäurehalogenid wird danach in äquivalenter Menge zugetropft. Anschließend wird das Reaktionsgemisch unter Rückfluss erhitzt, bis die gesamte Menge des bei der Reaktion entstehenden Hydrohalogenids vom Inertgasstrom entfernt worden ist. Durch dünnschichtchromatographische Kontrolle kann das Ende der Reaktion zusätzlich detektiert werden. Die Reaktionslösung wird dann abgekühlt und in mindestens die 2-fache Menge Wasser eingerührt. Dabei scheidet sich in den meisten Fällen ein Öl ab, welches nach einigen Stunden erstarrt ist. Die wässrige Phase wird abgetrennt und das Rohprodukt aus Ethanol umkristallisiert. Die Ausbeute beträgt jeweils mindestens 90%.

### aa) 2-Phenylessigsäurephenyl-1-naphthylamid

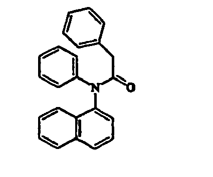

Auf diese Art wird beispielsweise 2-Phenylessigsäurephenyl-1-naphthylamid (mp:85 -88°C) aus Phenyl-1-naphthylamin und 2-Phenylacetylchlorid hergestellt.

### ab) 2-Phenylessigsäurediphenylamid

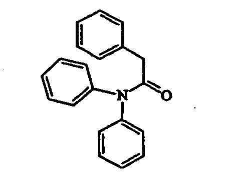

Auf diese Art wird beispielsweise 2-Phenylessigsäurediphenylamid (mp: 71-72°C) aus Diphenylamin und 2-Phenylacetylchlorid hergestellt.

### b) Synthese arylierter Thiocarbonsäureamide

0,5 mol des jeweiligen arylierten Carbonsäureamids und die äquivalente Menge Lawesson-Reagenz (hergestellt aus Anisol und Phosphorpentasulfid) werden in einer Rückflussapparatur mit Inertgasdurchfluss in 750 ml Diglykoldiethylether suspendiert, und dann wird 6 h bei 100°C gerührt. Dabei bildet sich eine klare Lösung, aus der in der Kälte in einigen Fällen das Reaktionsprodukt auskristallisiert. Um das Produkt vollständig zu isolieren, wird die Reaktionsmischung in die doppelte Menge Wasser eingerührt, die sich oft bildende ölige Phase lässt man dann kristallisieren. Danach wird das Produkt von der wässrigen Phase abgetrennt und aus Methanol umkristallisiert. Die Ausbeute beträgt jeweils mindestens 90%.

### ba) 2-Phenylthioessigsäurephenyl-1-naphthylamid

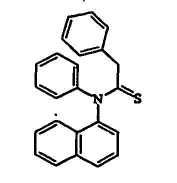

Auf diese Art wird beispielsweise 2-Phenylthioessigsäurephenyl-1-naphthylamid (mp: 100 - 103°C) aus 2-Phenylessigsäurephenyl-1-naphthylamid und dem Lawesson-Reagenz hergestellt.

### bb) 2-Phenylthioessigsäurediphenyl-amid

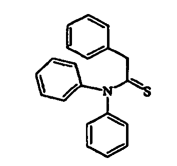

Auf diese Art wird beispielsweise 2-Phenylthioessigsäurediphenyl-amid (mp: 142-144°C) aus 2-Phenylessigsäurediphenylamid und dem Lawesson-Reagenz hergestellt.

### c) Darstellung von 2,2'-Diamino-4,4'-bisthienylarylenen

0,1 mol Bis-(haloacyl)-arylenderivat werden mit 0,2 mol 2-Aryl-thioessigsäurediarylamid in Tetrahydrofuran vorgelegt und 30 Minuten unter Stickstoffatmosphäre refluxiert. Nach 30 Minuten werden 0,2mol Trimethylamin zugegeben und nochmals 30 Minuten refluxiert. Das Produkt wird in Form farbloser Kristalle in Methanol gefällt.

### ca) 2,2'-Diphenylamino-3,3'-diphenyl-4,4'-bisthienyl-p-phenylen

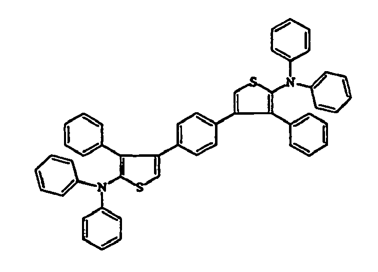

Auf diese Art wird beispielsweise 2,2'-Diphenylamino-3,3'-diphenyl-4,4'-bisthienyl-p-phenylen (mp: 232-235°C) aus 2-Phenyl-thioessigsäurediphenylamid und Bis-ω-Bromacetyl-p-phenylen hergestellt.

### Synthese konjugierter, kondensierter und oligo Arylsysteme C

### Beispiel 4:

### Synthese von 1,4-Diduryl-benzo-b-thiadiazol

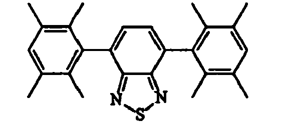

0,04 mol Durylboronsäure (Beispiel 1c) werden in einem 1-Liter 3-Halskolben mit 600ml Toluol vorgelegt, mit 0,04 mol Propandiol-(1,3) versetzt und am Wasserabscheider erhitzt bis kein Wasser mehr abgeschieden wird. Danach entfernt man den Wasserabscheider, ersetzt ihn durch einen Rückflusskühler und fügt der Reaktionsmischung 0,01 mol 1,4-Dibrom-benzo-b-thiadiazol und 11,6 g Pottasche, gelöst in 42 ml Wasser, zu. Nun wird der Kolben mehrfach am Vakuum evakuiert und mit Argon geflutet um den Katalysator, Tetrakis-triphenylphosphin-palladium, zuzugeben. Schließlich wird 48h auf 110°C erhitzt und während dieser Zeit mit Argon gespült. Zur Aufarbeitung wird die organische Phase mehrmals mit Wasser gewaschen, extrahiert und zur Trockene eingeengt. Der Rückstand wird in Methanol gewaschen und abgesaugt. Das Rohprodukt wird durch Chromatographie an Silicagel mittels Toluol gereinigt. Kontrolle des Produktes durch HPLC-MS Kopplung, M⁺ = 400.

### Synthese der Dibrom-arylene A*

### Beispiel 5:

### Darstellung von 2,7-Di-(4-Brom-2,3,5,6-tetramethyl-phenyl)-9,9-diheptyl-fluoren

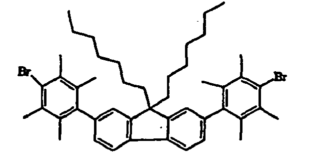

0.01 mol 2,7-Di-(2,3,5,6-tetramethyl-phenyl)-9,9-diheptylfluoren werden in 100 ml Chloroform gelöst, mit 0,5 g FeCl₃ versetzt und bei Raumtemperatur gerührt. In der Dunkelheit werden langsam 0.025 mol Brom, gelöst in Chloroform zugetropft. Die Reaktion wird ca. 12 Stunden gerührt. Wenn sich die Reaktionslösung entfärbt hat, ist die Bromierung beendet (DC-Kontrolle an Silicagel in Cyclohexan). Zur Aufarbeitung wird die Lösung mit Wasser gewaschen, die organische Phase extrahiert, danach das gesamte Chloroform abdestilliert und das Produkt in Methanol als weiße Kristalle gefällt, Kontrolle durch HPLC-MS-Kopplung, M⁺ = 783,785.

### Synthese der Dibrom-arylene B*

### Beispiel 6:

### Aufbau der Strukturen Ar²(a)

### a) Dialkylierung von 2-Bromfluoren

0,1 mol 2-Bromfluoren werden in DMSO unter Stickstoffatmosphäre bei ca. 50°C unter ständigem Rühren gelöst. Das gelöste 2-Bromfluoren wird mit 0,25 mol Kalium-tert.-butylat versetzt, woraufhin sich das Reaktionsgemisch dunkelrot färbt. Nach 5 Minuten werden 0,25 mol ein Alkylbromid R-Br zugegeben; die Reaktion läuft bei Raumtemperatur über Nacht und ist zu Ende, wenn ein Farbumschlag von rot nach hellgelb eintritt.

Die DMSO-Phase wird mit Wasser gewaschen und mit Ether extrahiert. Der Ether wird mittels Rotationsverdampfer abdestilliert und das Produkt in Form hellgelber Kristalle mit Methanol gefällt.

### aa) 2-Brom-9,9-diheptylfluoren

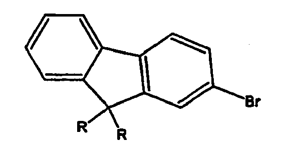

Auf diese Art wird beispielsweise 2-Brom-9,9-diheptylfluoren (mp: 32°C) aus 2-Bromfluoren und Heptylbromid in Gegenwart von Kalium-tert.-butylat hergestellt.

### b) Chloracetylierung von 9,9-Dialkyl-2-bromfluorenen

0,1 mol 9,9-Diheptyl-2-bromfluoren werden in Methylenchlorid vorgelegt und mit flüssigem Stickstoff auf -15°C gekühlt. Bei -15°C werden 0,15 mol Chloracetylchlorid und daraufhin 0,3 mol Aluminiumchlorid langsam zugegeben. Die Reaktion wird nun über Nacht (mindestens 12h) gerührt.

Das Gemisch wird in Eis/Wasser/HCl (500ml:500ml:50ml) geschüttet und 20 Minuten gerührt. Danach wird nochmals mit Wasser gewaschen. Die organsiche Phase wird abgetrennt und das Lösungsmittel abdestilliert. Das Produkt fällt in Form weißer Kristalle in Methanol aus.

### ba) 2-Brom-7-chloracetyl-9,9-diheptylfluoren

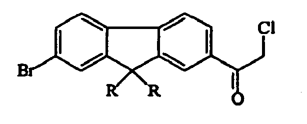

Auf diese Art wird beispielsweise 2-Brom-7-chloracetyl-9,9-diheptylfluoren (mp: 83-4°C) aus 2-Brom-9,9-diheptylfluoren und Chloracetylchlorid unter Friedel-Crafts-Bedingungen hergestellt.

### c) Darstellung arylierter 2-Aminothiophenderivate

0,1 mol Haloacylarylderivat werden mit 0,1 mol 2-Phenylthioessigsäurediarylamid (Beispiel 3b) in Tetrahydrofuran vorgelegt und 30 Minuten unter Stickstoffatmosphäre refluxiert. Nach 30 Minuten werden 0,1mol Trimethylamin zugegeben und nochmals 30 Minuten refluxiert. Das Produkt wird in Form gelblicher Kristalle in Methanol gefällt.

### ca) 2-(Phenyl-1-naphthylamino)-3-phenyl-4-p-bromphenylthiophen

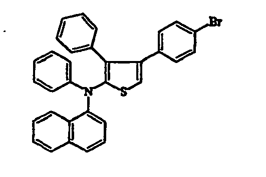

Auf diese Art wird beispielsweise 2-(Phenyl-1-naphthylamino)-3-phenyl-4-p-bromphenylthiophen (ESI-MS: M+1⁺ = 532) aus 2-Phenylthioessigsäurephenyl-1-naphthylamid und p-Bromphenacylbromid hergestellt.

### cb) 2-(Phenyl-1-naphthylamino)-3-phenyl-4-(7-brom-9,9-diheptyl-fluoren-2-yl)-thiophen

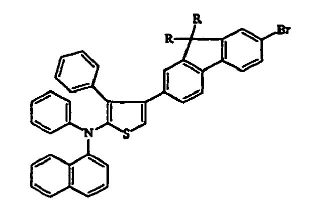

Auf diese Art wird beispielsweise 2-(Phenyl-1-naphthylamino)-3-phenyl-4-(7-brom-9,9-diheptyl-fluoren-2-yl)-thiophen mit R= Heptyl (ESI-MS: M+1⁺ = 816) aus 2-Phenylthioessigsäurephenyl-1-naphthylamid und 2-Chloracetyl-7-brom-9,9-diheptyl-fluoren hergestellt.

### d) Darstellung von Dibromarylenderivaten mit Lochtransporteigenschaften durch Oxydation der 2-Aminothiophenderivate

0,1 mol 2-Aminothiophenderivat werden mit 0,5 mol FeCl₃ in Methylenchlorid vorgelegt und einen Tag gerührt. Das Produkt wird mit Wasser und 0,1 mol Triethylamin versetzt und das organische Lösungsmittel abdestilliert. Das Produkt fällt nun in Form von gelben Kristallen in der zurückbleibenden Wasserphase aus. Reinigung durch Säulenchromatographie an Silicagel mit Toluol)

### da) Bis-[2-(Phenyl-1-naphthylamino)-3-phenyl-4-(7-brom-9,9-diheptyl-fluoren-2-yl]-5,5'-thienyl

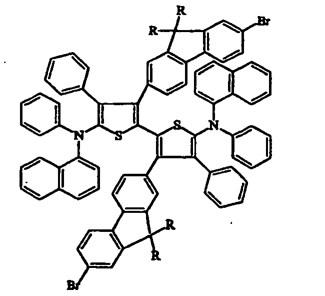

Auf diese Art wird beispielsweise Bis-[2-(Phenyl-1-naphthylamino)-3-phenyl-4-(7-brom-9,9-dialkyl-fluoren-2-yl]-5,5'-thienyl mit R= Heptyl (ESI-MS: M+1⁺ = 1629) aus 2-(Phenyl-1-naphthylamino)-3-phenyl-4-(7-brom-9,9-diheptylfluoren-2-yl-thiophen und Eisen-III-chlorid hergestellt.

### db) Bis-[2-(Phenyl-1-naphthylamino)-3-phenyl-4-(4-bromphenyl)]-5,5'-thienyl

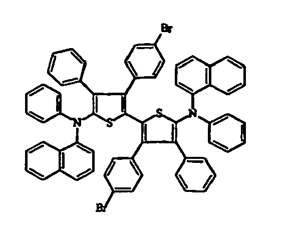

Auf diese Art wird beispielsweise Bis-[2-(Phenyl-1-naphthylamino)-3-phenyl-4-(4-bromphenyl)]-5,5'-thienyl (mp: 133-4°C), (ESI-MS: M+1⁺ = 1061) aus 2-(Phenyl-1-naphthylamino)-3-phenyl-4-(4-bromphenyl)-thiophen und Eisen-III-chlorid hergestellt.

### Synthese der Dibrom-arylene C*

### Beispiel 7:

### Aufbau der Strukturen Ar³(e)

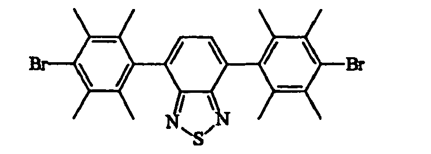

0.01 mol 1,4-Diduryl-benzo-b-thiadiazol (Beispiel 4) werden in 100 ml Chloroform gelöst, mit 0,5 g FeCl₃ versetzt und bei Raumtemperatur gerührt. In der Dunkelheit werden langsam 0.025 mol Brom, gelöst in Chloroform zugetropft. Die Reaktion wird ca. 12 Stunden gerührt. Wenn sich die Reaktionslösung entfärbt hat, ist die Bromierung beendet (DC-Kontrolle an Silicagel in Toluol). Zur Aufarbeitung wird die Lösung mit Wasser gewaschen, die organische Phase extrahiert, danach das gesamte Chloroform abdestilliert und das Produkt in Methanol in Form gelblicher Kristalle gefällt, Kontrolle durch ESI-MS (M+1⁺ = 557).

### Synthese der Bromarylsysteme (R-Br)

### Beispiel 8:

### Synthese von 4-Brom-2,3,5,6-tetramethyl-phenyl-diphenylamin

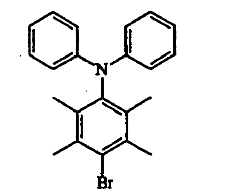

In einer Apparatur zum Arbeiten unter inerten Bedingungen und Feuchtigkeitsausschluß wird 0,1 mol Diphenylamin, 0,4 mol Dibromdurol und 0,12 mol Natrium-tert.-butylat vorgelegt. Als Katalysator zur C-N-Kupplung wird Pd₂(dba)₃/(t.-Bu)₃P = 1/6 in einer Konzentration von 1 Mol% bezogen auf das Amin eingesetzt. Die Reaktionslösung wird am Rückfluß erhitzt bis man durch DC-Vergleich kein Diphenylamin mehr nachweisen kann. Zur Aufarbeitung wäscht man die Reaktionslösung neutral und extrahiert die organische Phase. Danach entfernt man das Lösungsmittel im Vakuum, fügt 200 ml Cyclohexan zu und saugt den unlöslichen Kristallbrei von Dibromdurol ab. Das Filtrat wird bis zur erneuten, beginnenden Kristallisation eingeengt und an Silicagel mit Cyclohexan chromatographiert. Kontrolle durch HPLC-MS-Kopplung (C18RP/10µm/Methanol/RT = 7,06 min/99%, M⁺ = 379).

### Synthese der lithiierten Arensysteme D, E, F und I*

### Beispiel 9:

### Allgemeine Vorschrift

In einer, wie in der metallorganischen Chemie üblichen, Apparatur werden unter Feuchtigkeitsausschluß und inerter Atmosphäre 0,1 mol hoch gereinigte und getrocknete Dibrom-arylenkomponente (A*, B*, C*), Bromarylkomponente(R-Br) bzw. die unbromierten Arene (A, B, C) mit terminalen Thiophensubstituenten in 600 ml THF gelöst und auf -78°C abgekühlt. Danach wird Butyllithium in 20%-igem Überschuß durch ein Septum langsam zugegeben und die Temperatur noch für eine weitere Stunde auf -78°C gehalten. Die lithiierten Arene können nach dem Auftauen direkt aus der Lösung weiter-verarbeitet werden. Die Synthese der benötigten lithiierten Arene für die Polymersynthese sollte möglichst parallel durchgeführt werden, um sie frisch einsetzten zu können.
a) 9,9-Diheptyl-2,7-fluoren-ylen-dilithium 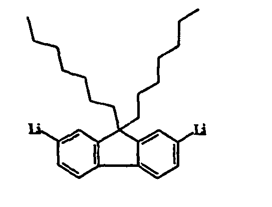 Auf diese Art wird beispielsweise 9,9-Diheptyl-2,7-fluorenylen-dilithium aus 9,9-Diheptyl-2,7-dibromfluoren und Butyllithium hergestellt.
b) Diphenylamino-2,3,5,6-tetramethyl-phenyl-4-yl-lithium 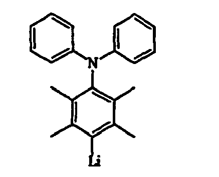 Auf diese Art wird beispielsweise Diphenylamino-2,3,5,6-tetramethyl-phenyl-4yl-lithium aus 4-Brom-2,3,5,6-tetramethyl-phenyl-diphenylamin und Butyllithium hergestellt.

### Synthese der grignardierten Arensysteme D*,E*, F* und I

### Beispiel 10:

### Allgemeine Vorschrift

0,25 mol frisch geätzte Magnesiumspäne werden unter Argonatmosphäre in trockenem Ether vorgelegt. Unter Rühren und Refluxieren werden 0,1 mol hochgereinigte und getrocknete Dibrom-arylenkomponente (A*, B*, C*) bzw. Bromarylkomponente (R-Br), gelöst in 300 ml THF, so zugetropft, daß die Reaktionsmischung nach dem Reaktionsstart beim Sieden gehalten wird. Das Ende der Reaktion wird durch DC festgestellt, indem die organische Phase einer mit Wasser versetzte Probe mit dem jeweiligen bromierten und unbromierten Aren verglichen wird. Wird das jeweilige unbromierte Aren detektiert steht die grignardierte Arenlösung der Weiterarbeit zur Verfügung. Die Synthese der benötigten Grignardverbindungen für die Polymersynthese sollte möglichst parallel durchgeführt werden, um sie frisch einsetzten zu können.

### a) 9,9-Diheptyl-2,7-fluoren-ylen-dimagnesiumbromid

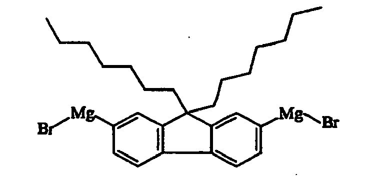

Auf diese Art wird beispielsweise 9,9-Diheptyl-2,7-fluorenylen-magnesiumbromid aus 9,9-Diheptyl-2,7-dibromfluoren und Magnesium hergestellt.

### Synthese der Arylboronsäurederivate G*

### Bespiel 11:

### Darstellung von Arylboronsäureestern / allgemeine Vorschrift

Eine der nach Beispiel 9 synthetisierten Aryllithiumverbindungen oder eine der nach Beispiel 10 synthetisierten Aryl-Grignard-Verbindungen wird bei -78°C unter Feuchtigkeitsausschluß und inerten Bedingungen zu einer etherischen Lösung, die ein Äquivalent Borsäuretrimethylester enthält, langsam zugetropft. Nach Auftauen auf Raumtemperatur wird noch 12h gerührt, anschließend steht die Reaktionslösung zur werteren Umsetzung zur Verfügung.

### a) Mesitylboronsäuredimethylester

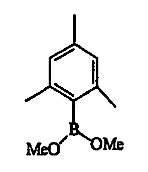

Auf diese Art wird beispielsweise Mesitylboronsäuredimethylester aus Mesitylmagnesiumbromid und Borsäuretrimethylester hergestellt.

### Synthese der linearen Co-polyfluorarylenborane H

### Beispiel 12:

### Allgemeine Vorschrift

Die gewünschten Anteile der vorbereiteten Grignardverbindungen (D*, E* und F*) oder die entsprechenden Lithiumorganyle D, E und F) gelöst in THF werden unter Argon und Feuchtigkeits-ausschluß in einen Kolben überführt, der mit Tropftrichter, Rückflußkühler, Rührer und Argonatmosphäre ausgestattet ist. Über ein Septum wird Bortrifuoridetherat entsprechend der Summe der molaren Anteile der Grignardvervindungen in den Tropftrichter dosiert und bei Raumtemperatur innerhalb von 30 min zugetropft. Man erhöht die Temperatur nach dem Zutropfen auf 60°C, nach weiteren 2h Reaktionszeit steht das nun gebildete Co-polyfluorarylenboran **H** der nächsten Reaktion zur Verfügung.

### a) Poly-fluor-(9,9-diheptyl)- 2,7-fluorenylen-boran

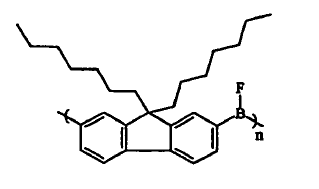

### Auf diese Art wird beispielsweise Poly-fluor-(9,9-diheptyl)-2,7-fluorenylen-boran aus 9,9-Diheptyl-2,7-fluorenylen-magnesium-bromid und Bortrifluoridetherat hergestellt.

### Synthese der Co-Polyborane K

### Beispiel 13:

### a) aus Co-polyfluorarylenboran H und einem Magnesiumorganyl I bzw. einem Lithiumorganyl I*

Zuerst wird der Rückflußkühler der Apparatur durch eine Destillationsbrücke ersetzt und das Lösungsmittel THF abdestilliert. Gleichzeitig wird der Tropftrichter etwa volumengleich der Reaktionsmischung mit trockenem Toluol befüllt und als Lösungsmittel anstelle des THF zugetropft. Nach Abschluß des Lösungsmittelaustausches wird die gewünschte gelöste Grignardverbindung **I** bzw. Aryllithiumverbindung **I*** unter Argonatmosphäre und Feuchtigkeitsausschluß in stöchiometrischem Verhältnis bezogen auf das Co-polyfluorarylenboran **H** in den Tropftrichter dosiert und bei leicht siedendem Toluol langsam zugetropft. Dabei destilliert man gleichzeitig das Lösungsmittel (THF) der zutropfenden Grignardverbindung **I** bzw. Aryllithiumverbindung **I*** ab. Nach Abtrennung des THF tauscht man die Destillationsbrücke wieder gegen den Rückflußkühler und erhitzt noch weitere 5h am Rückfluß.

Die Reaktionsmischung wird nach Abkühlung auf Eis/HCl gegossen und die Toluolphase abgetrennt. Das Toluol wird am Rotationsverdampfer vollständig abdestilliert, danach der Rückstand in wenig THF gelöst und unter Rühren in Ethanol gefällt. Weitere Reinigung des Produktes erfolgt durch wiederholtes Lösen in THF und erneutes Ausfällen in Ethanol.

### aa) Poly-mesityl-(9,9-di-heptyl)-2,7-fluorenylen-boran

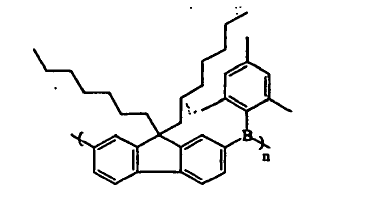

Auf diese Art wird beispielsweise Poly-mesityl-(9,9-diheptyl)-2,7-fluorenylen-boran (MW: 21000 Tg: 110°C, CV reversibel bei Reduktion) aus Poly-fluor-(9,9-diheptyl)-2,7-fluorenylen-boran und Mesityl-magnesium-bromid hergestellt.

### ab) Poly-(2-diphenylamino-3,4-diphenyl-thien-5-yl)-(9,9-diheptyl-2,7-fluorenylen)-boran

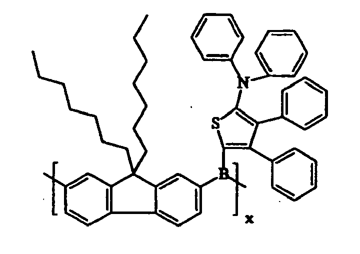

Auf diese Art wird beispielsweise Poly-(2-diphenylamino-3,4-diphenyl-thien-5-yl)-(9,9-di-heptyl-2,7-fluorenylen)-boran (MW: 19000, Tg: 135°C, CV: reversibel bei Oxydation und Reduktion) aus Poly-fluor-(9,9-diheptyl)-2,7-fluorenylen-boran und 2-Diphenylamino-3,4-diphenyl-thiophen hergestellt.

### ac) Poly-(4-diphenylamino-2,3,5,6-tetramethyl-phenyl)-[(9,9-di-heptyl)-2,7-di-(2,3,5,6-tetramethyl-phen-4-yl)-fluorenylen]-boran

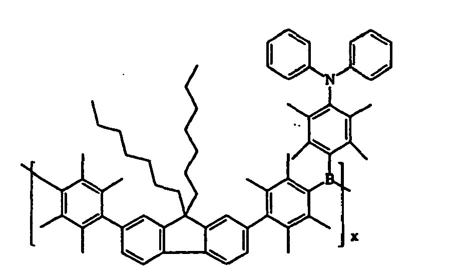

Auf diese Art wird beispielsweise Poly-(4-diphenylamino-2,3,5,6-tetramethyl-phenyl)-[(9,9-di-heptyl)-2,7-di-(2,3,5,6-tetramethyl-phen-4-yl-fluorenylen)]-boran aus Poly-fluor-[(9,9-di-heptyl)-2,7-di-(2,3,5,6-tetramethyl-phen-4-yl)-fluorenylen]-boran und 4-Brom-2,3,5,6-tetramethyl-phenyl-diphenylamin hergestellt.

### Cyclovoltammetrie: an Polymer ac zeigt die gewünschte oxidative und reduktive Reversibilität und Stabilität über mehrere Cyclen.

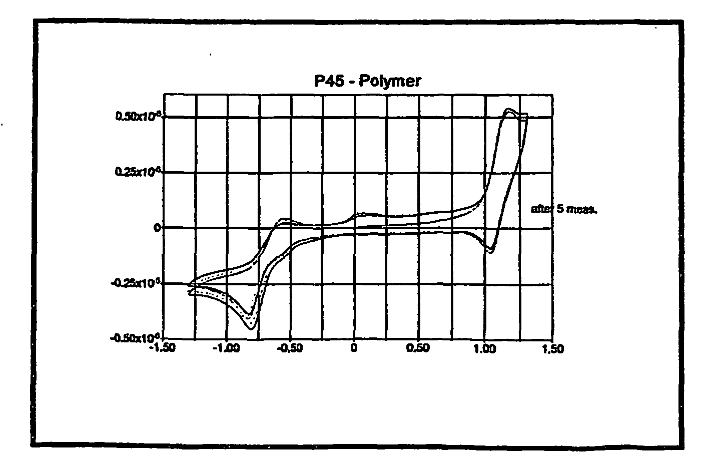

### b) aus den Metallorganylen (D, D*, E, E*, F, F*) und einem Arylboronsäureester G*

Unter absolut trockenen und inerten Bedingungen werden die zur Bildung des gewünschten Copolyborans benötigten Metallorganyle in einem Kolben entsprechend der gewünschten Stöchiometrie gemischt und anschließend unter Rühren der gewünschte Arylboronsäureester im stöchiometrischen Verhältnis zugegeben.
Die Temperatur wird zunächst für 2h auf 60°C erhöht anschließend wird der Rückflußkühler der Apparatur durch eine Destillationsbrücke ersetzt und das Lösungsmittel THF abdestilliert. Gleichzeitig wird der Tropftrichter etwa volumengleich der Reaktionsmischung mit trockenem Toluol befüllt und als Lösungsmittel anstelle des THF zugetropft. Nach Abschluß des Lösungsmittelaustausches tauscht man die Destillationsbrücke wieder gegen den Rückflußkühler und erhitzt noch weitere 5h am Rückfluß.

Die Reaktionsmischung wird nach Abkühlung auf Eis/HCl gegossen und die Toluolphase abgetrennt. Das Toluol wird am Rotationsverdampfer vollständig abdestilliert, danach der Rückstand in wenig THF gelöst und unter Rühren in Ethanol gefällt. Weitere Reinigung des Produktes erfolgt durch wiederholtes Lösen in THF und erneutes Ausfällen in Ethanol.

### ba) Poly-[(mesityl-(9,9-di-heptyl-2,7-fluorenylen)-co-polymesityl-N,N'-Diphenyl-N,N'-dithien-3-phenyl-4-(4-octylphenyl)-2-yl-5,5'-ylen-phenylen-1,4-diamin]-boran

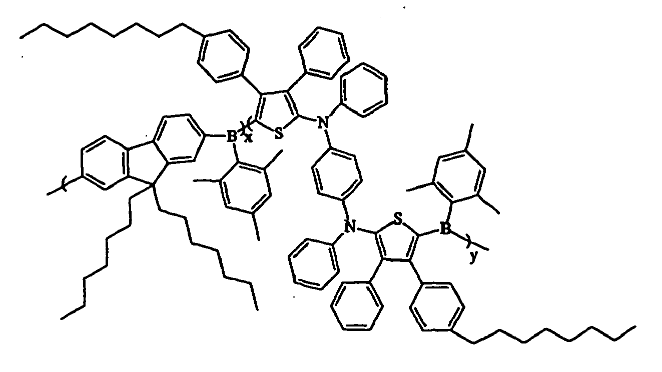

Auf diese Art wird beispielsweise das Copolymer ba (CV reversibel bei Oxydation und Reduktion, MW: 20000) aus 0,8 molaren Teilen der substituierten Fluorenkomponente, 0,2 molaren Teilen der substituierten Diaminkomponente und 1,0 molaren Teilen des Mesitylboronsäuredimethylesters herge-stellt.

### OLED Charakteristik

### Beispiel 14:

Eine OLED wurde durch folgende Schichtreihenfolge aufgebaut:
Anode: ITO (Indium-Zinnoxid)
80nm Pedot
80nm Emitter (Poly-mesityl-(9,9-di-heptyl)-2,7-fluorenylenboran)(nach Beispiel 13aa)
Kathode 3nm Ba, 300nm Al

### a) Stromdichte

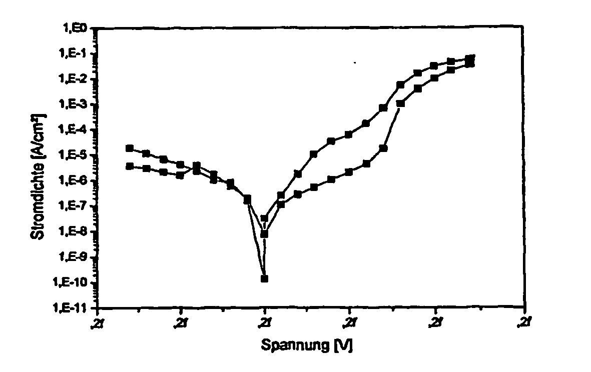

### b) Effizienz

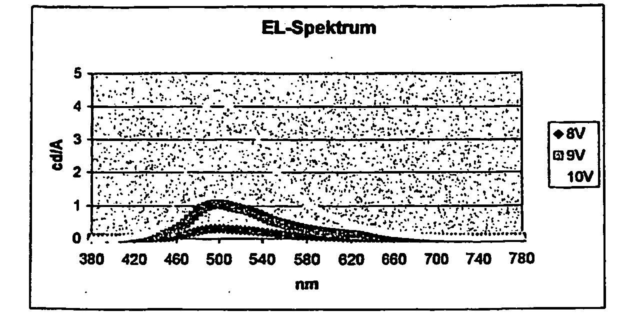

### c) CIE-Daten der OLED: 0,24 x 0,46 (bei 10V)

Die neuen Materialien eignen sich zur Erzeugung von elektrolumineszierenden Dioden in den verschiedenen Farben des sichtbaren Spektralbereiches (blau bis rot). Ebenso lassen sich diese Materialien durch Poly-co-reaktionen in entsprechenden Verhältnissen in Materialien umwandeln, die am bzw. in der Nähe des Weißpunktes elektrolumineszieren.

Diese polymeren Materialien lassen sich durch alle aus Lösung applizierbaren Verfahren verarbeiten (z. B. spin coating, Rakeln, Siebdrucken, Tintenstrahldrucken).

Die Materialien sind präperativ in hohen Ausbeuten zugänglich und leiten sich von arylierten Boranen ab, wobei durch die Wahl der Arylenfragmente (Donor/Akzeptor-Struktur) die elektronischen Eigenschaften und damit auch die Farbe der jeweiligen Verbindung beeinflußt wird.

Insbesondere ist hervorzuheben, dass zum Aufbau dieser polymeren Materialien keine wie sonst übliche metall-katalysebasierende Kupplungsreaktionen benötigt werden, (damit entfällt auch die aufwendige Abtrennung des Katalysators sowie die Gefahr der Verunreinigung des Polymers durch Quencherpartikel), was die Kosten für die Synthese, infolge der nicht benötigten teuren Palladiumkatalysatoren und deren Abtrennung, stark reduziert.

Gerade weiß emittierende Materialien sind für die Herstellung von Leuchtquellen und vollfarbigen Displays, bei welchen die Vollfarbigkeit durch Filterung erreicht wird, von großem Interesse. Der Vorteil bei den Weißlicht getriebenen vollfarbigen Displays besteht in der farbunabhängigen Alterung des emittierenden Materials.

## Patentansprüche

1. Polyarylborane des Typs K, 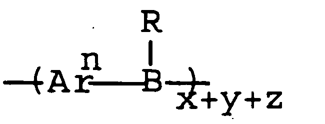 wobei Folgendes gilt:
**x,y** und **z** sind molare Teile von Komponenten und ergeben in Summe gleich 1, wobei zwei der Indizes **x,y** und **z** auch den Wert 0 haben können,
an den Enden sind Wasserstoff-Atome gebunden,
**Arⁿ** steht für die jeweilige Arylenkomponente, **-Ar¹-** und/oder **-Ar²-** und/oder **-Ar³-** im Copolymer, wobei die Copolyarylborane des Typs K eine Arylenkomponente **-Ar3-** enthalten,
dabei stehen **Ar¹** und **Ar²** für Komponenten mit einer bivalent konjugativ verbindenden ein- oder mehrkernigen, (homo-) aromatischen und/oder heteroaromatischen Arylenstruktur, wobei **Ar¹** für eine Komponente steht, deren π-Elektronendichte gleich oder größer als die von Benzol ist und **Ar²** für eine Komponente, die lochtransportfähig ist,
wobei **Ar³** ausgewählt ist aus den in Tabelle 3 gezeigten Verbindungen der Typen **Ar³(a-m),**
**Tabelle3**
| | |
|---|---|
| 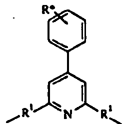 | |
| **Ar³(a1)** 2,6-(Diarylen)-pyridinylene | |
| 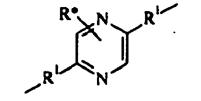 | 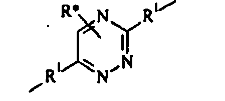 |
| **Ar³(b)** 2,5-(Diarylen)-pyrazinylene | **Ar³(c)** 3,6-(Diarylen)-1,2,4-triazinylene |
| 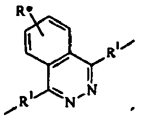 | 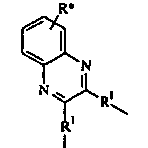 |
| **Ar³(d1)** 1,4-(Diarylen)-phthalazinylene | **Ar³(d2)** 2,3-(Diarylen-chinoxalinylene |
| 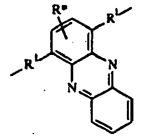 | 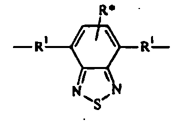 |
| **Ar³(d3)** 1,4-(Diarylen)-phenazinylene | **Ar³(e)** 1,4-(Diarylen)-benzothiadiazolylene |
| 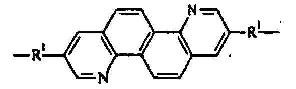 | 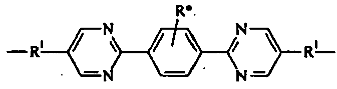 |
| **Ar³(f)** 3,9-(Diarylen)-1,7-diaza-chrysenylene | **Ar³(g1)** Bis-(2,2'-(diarylen)-pyrimidin-5,5'-ylen)-arylene |
| 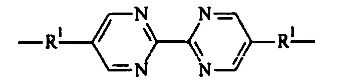 | 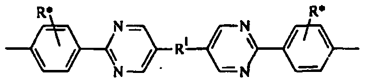 |
| **Ar³(g2)** 2,2'-Pyrimidin-5,5'-(diarylen)-ylene | **Ar³(h)** Bis-[5,5'-(diarylen)-pyrimidin-2,2'-ylen]-arylene |
| 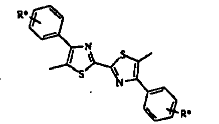 | 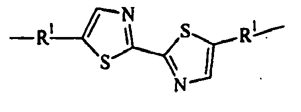 |
| **Ar³(i1)** 2,2'-(5,5'-bis-1,3-thiazolylene) | **Ar³(i2)** 2,2'-(5,5'arylen-bis-1,3-thiazolylene) |
| 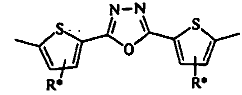 | 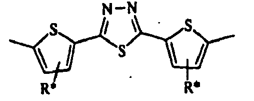 |
| **Ar³(j1)** 5',5'-bis-[2,5-(di-2',2'-thienyl)-oxadiazolylene] | **Ar³(j2)** 5',5'-bis-[2,5-(di-2',2'-thienyl)-thiadiazolylene] |
| 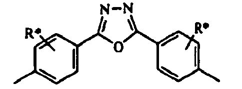 | 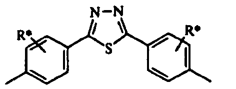 |
| Ar³(k1) 4',4'-bis-(2,5-diphenyl-oxadiazolylene) | **Ar³(k2)** 4',4'-bis-(2,5-diphenyl-thiadiazolylene) |
| 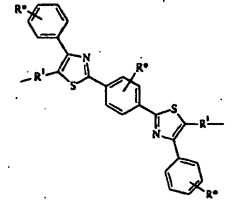 | 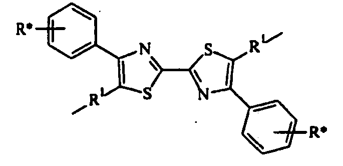 |
| **Ar³(l1)** 2,2'-(5,5'arylen-bis-1,3-thiazolylen)-arylene | **Ar³(l2)** 2,2'-(5,5'arylen-bis-1,3-thiazolylene) |
| 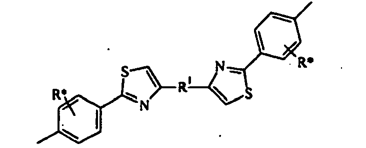 | 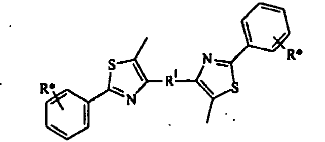 |
| **Ar³(m1)** 4,4'-(2,2'arylen-bis-1,3-thiazolylen)-arylene | **Ar³(m2)** 4,4'-(5-,5-ylen-bis-1,3-thiazolylen)-arylene |
die Bedeutung der Substituenten **R¹** ist hierbei gleichbedeutend mit der Substituentenauswahl für die Arylenkomponente **Ar¹,**
wobei die Arylenkomponente **Ar³** eine geringe π-Elektronendichte, die gleich oder kleiner als die des Benzols ist, aufweist
wobei die n-Elektronendichte von **Ar³** in jedem Fall kleiner als die von **Ar¹** ist,
und
**R** steht für einen Rest mit Arylstruktur, der je nach beabsichtigter Konjugation des Polyborans **K** einen heteroaromatischen und/oder einen (homo)-aromatischen Arylrest umfasst,
- der donorfrei ist, wobei eine Konjugation im Polyboran **K** durch Anlegen eines elektrischen Feldes ausgebildet werden kann, und/oder
- bei dem mindestens eine zusätzliche Donorfunktion substituiert ist (intrinsische Konjugationsausbildung) und/oder
- dessen Wasserstoffatome auch beliebig durch einen oder mehrere verzweigte oder unverzweigte Alkylreste oder Alkoxyreste **R*,** substituiert sein können.

2. Polyarylboran nach Anspruch 1, bei dem die Arylenkomponente(n) **Arⁿ** und/oder der Arylsubstituenten **R** eine oder beide ortho-Stellungen der Bor-Kohlenstoff-Bindungen substituiert hat.

3. Polyarylboran nach einem der Ansprüche 1 oder 2, bei dem die Arylenkomponente(n) **Arⁿ** und/oder die Arylsubstituenten **R** ausgewählt ist aus der Gruppe folgender Verbindungen: 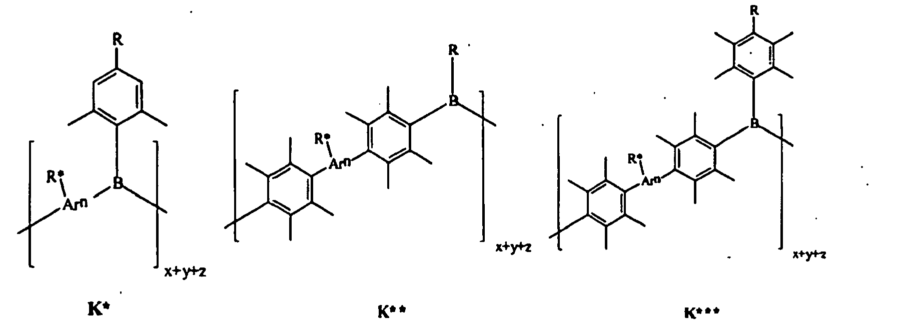 wobei unter dem Begriff Aryl- und/oder Arylenkomponente ein konjugiertes System von mindestens einer cyclischen Teilstruktur verstanden werden, die im Falle von mehreren cyclischen Teilstrukturen auch von Vinyleneinheiten unterbrochen sein können, wobei die cyclischen Teilstrukturen aromatischer Natur sind, d.h. aus Kohlenstoff oder aus Kohlenstoff und anderen Elementen bestehenden Ringen erzeugt werden, deren Anzahl von π-Elektronen (4n+2) entspricht (n ist ein Parameter der die Zahlen 0 bis 5 annehmen kann) und deren sonstige σ-Bindungen bis auf eine, im Falle der monovalenten Arylstruktur, bzw. zwei, im Falle der bivalenten Arylenstruktur mit Wasserstoff und/oder beliebigen sonstigen Substituenten verknüpft sind.

4. Polyarylboran nach Anspruch 2 oder 3, bei dem zumindest ein orthoständiger Substituent ein Methylsubstituent und/oder zwischen Bor und einer Arylenkomponente ein 3,6 Durylensubstituent angeordnet ist.

5. Polyarylborane nach einem der Ansprüche 1 bis 4, wobei **Ar¹** eine 2,7-Fluorenylenstruktur, die in 9-Position durch unverzweigte und/oder verzweigte Alkylreste substituiert sein kann, hat.

6. Polyarylborane nach einem der vorstehenden Ansprüche, wobei **Ar¹** ausgewählt ist aus den in Tabelle 1 gezeigten Verbindungen der Typen **Ar¹(a-h)** Tabelle 1
| | | |
|---|---|---|
| 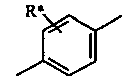 | 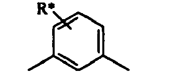 | 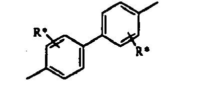 |
| **Ar¹(a1)** 1,4-phenylen | **Ar¹(a2)** 1,3-phenylen | **Ar¹(b1)**1,1'-(4,4'-biphenylen) |
| 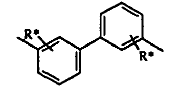 | 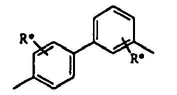 | 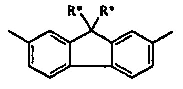 |
| **Ar¹(b2)** 1,1'-(3,3'-biphenylen) | **Ar¹(b3)** 1,1'-(3,4'-biphenylen) | **Ar¹(c)** 2,7-fluorenylen |
| 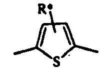 | 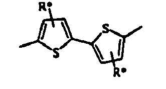 | 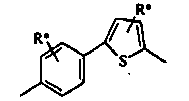 |
| **Ar¹(d)** 2,5-thienylen | **Ar¹(e)** 2,2'-(5,5'-bis-thienylen) | **Ar¹(f1)** 4',5-(2-phenylthienylen) |
| 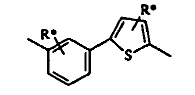 | 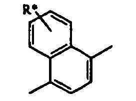 | 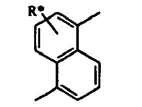 |
| **Ar¹(f2)** 3',5-(2-phenylthienylen) | **Ar¹(g1)** 1,4-naphthylen | **Ar¹(g2)** 1,5-naphthylen |
| 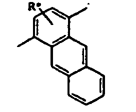 | 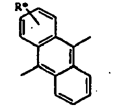 | 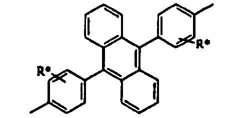 |
| **Ar¹(h1)** 1,4-anthrylen | **Ar¹(h2)** 9,10-anthrylen | **Ar¹(h3)** 4',4'-bis-(9,10-diphenyl)-anthrylen |

7. Polyarylborane nach einem der vorstehenden Ansprüche, wobei **Ar²** über konjugativ verknüpfte perarylierte Aminsubstituenten verfügt.

8. Polyarylborane nach einem der vorstehenden Ansprüche, wobei **Ar²** ausgewählt ist aus den in Tabelle 2 gezeigten Verbindungen der Typen **Ar²(a-f),**
**Tabelle 2**
| |
|---|
| 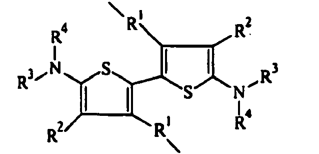 |
| **Ar² (a)** [bis-(2,2'diarylamino-3,3'-diaryl-5,5'thien)]-4,4'-ylen |
| 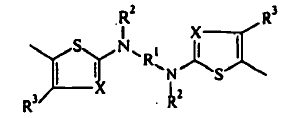 |
| **Ar²(b)** [N,N'-bis-(thien-2-yl)- bzw. N,N'-bis-(1,3-thiazol-2-yl)-N,N'-diaryl-diaminoarylen]-5,5'-ylen |
| 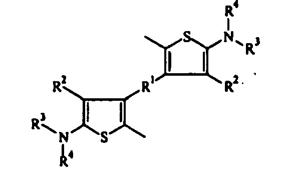 |
| **Ar²(c)** [bis-(2,2'-diarylamino)-3,3'-diaryl-4,4'-thienyl)-arylen]-5,5'-ylen |
| 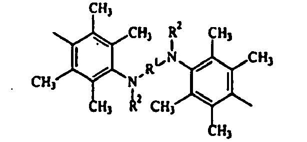 |
| **Ar²(d)** [N,N'-bis-(3-duryl)-N,N'-diaryl-diaminoarylen]-6,6'-ylen |
| 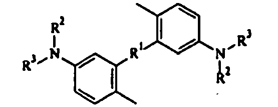 |
| **Ar²(e)** Bis-[(5,5'-diarylamino-phenyl)-arylen]-2,2'-ylen |
| 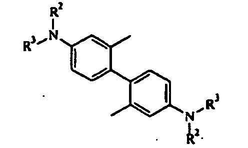 |
| **Ar²(f)** bis-(4,4'-diarylamino-phenyl)2,2'-ylen |

9. Polyarylborane nach einem der vorstehenden Ansprüche wobei die Substituenten **R², R³** und **R⁴** von **Ar²** ausgewählt sind aus der Gruppe folgender Verbindungen: Phenyl, 1-Naphthyl und 2-Naphthyl.

10. Polyarylborane nach einem der vorstehenden Ansprüche wobei **R** ausgewählt ist aus den in Tabelle 4 gezeigten Verbindungen der Typen
- **[R(a1-a5)]** donorfrei,
- **[R(b-e)]** bei denen mindestens eine Donorfunktion substituiert ist und/oder
- **R(f)**
**Tabelle 4:**
| | | |
|---|---|---|
| 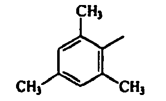 | 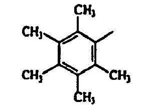 | 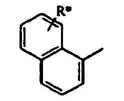 |
| **R(a1)** mesityl | **R(a2)** pentamethylphenyl | **R(a3)** 1-naphthyl |
| 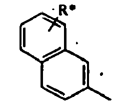 | 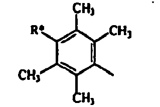 | |
| **R(a4)** 2-naphthyl | **R(a5)** 3-alkyl/alkoxy-dur-6-yl | |
| 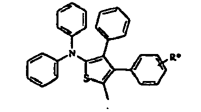 | 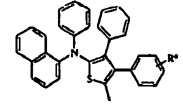 | 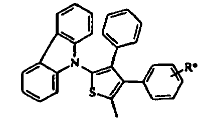 |
| **R(b1)** 2-diphenylamino-3,4-diphenyl-thien-5-yl | **R(b2)** 2-[(1-naphthyl)-phenylamino]-3,4-diphenyl-thien-5-yl | **R(b3)** 2-(N-carbazoyl)-3,4-diphenyl-thien-5-yl |
| 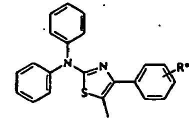 | 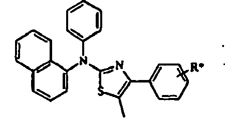 | |
| **R(c1)** 2-diphenylamino-3,4-diphenyl-1,3-thiazol-5-yl | **R(c2)** 2-[(1-naphthyl)-phenylamino]-3,4-diphenyl-1,3-thiazol-5-yl | |
| 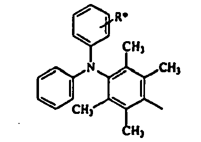 | 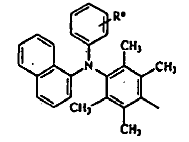 | 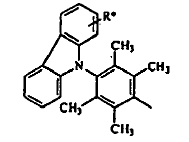 |
| **R(d1)** 3-diphenylamino-dur-6-yl | **R(d2)** 3-[(1-naphthyl)-phenylamino]-dur-6-yl | **R(d3)** 3-(N-carbazoyl)-dur-6-yl. |
| 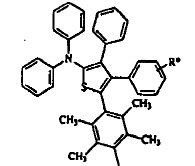 | 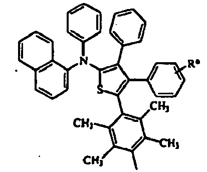 | 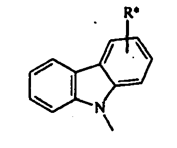 |
| **R(e1)** 2-diphenylamino-3,4- diphenyl-5-(3-dur-6-yl)-thiophen | **R(e2)** 2-[(1-naphthyl)-phenylamino]-3,4-diphenyl-5-(3-dur-6-yl)-thiophen | **R(f)** N-carbazoyl |

11. Polyarylborane nach einem der vorstehenden Ansprüche, deren Löslichkeit in organischen Lösungsmitteln durch zusätzliche beliebige Anordnung von einem oder mehreren unverzweigten und/oder verzweigten Alkylsubstituenten und/oder Alkoxysubstituenten **R*** verbessert ist.

12. Polyarylborane nach einem der vorstehenden Ansprüche, wobei einer oder mehrere der Alkyl- und/oder Alkoxyreste 1 bis 10 Kohlenstoffatome hat.

13. Verfahren zur Herstellung der Polyarylborane des Typs **K** nach einem der vorhergehenden Ansprüche nach dem allgemeinen Herstellungsschema.
Reaktionsschema: 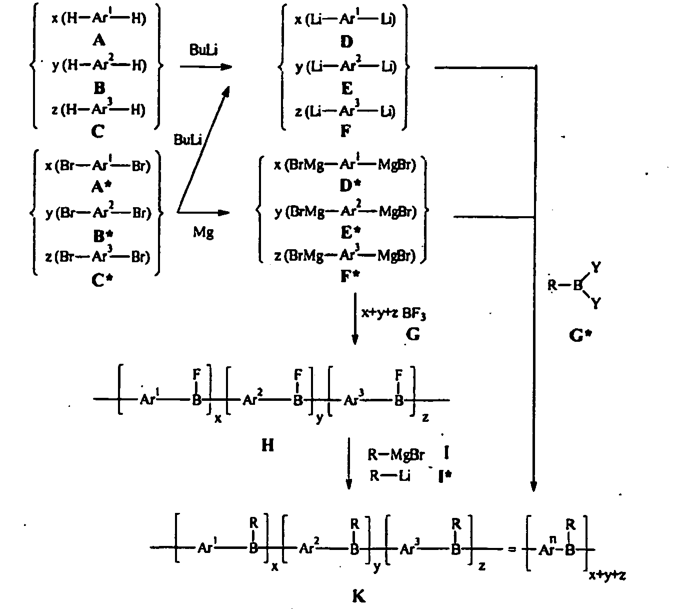 wobei von den Arenen **A** bis **C** bzw. von den bromsubstituierten Arylenstrukturen **A*** bis **C*** ausgegangen wird, diese werden entweder durch eine Grignardreaktion (**D*** bis **F***) oder durch Lithiierung (**D** bis **F**) umgepolt, darauffolgend wird einer der Reaktionswege **G** oder **G*** zur Bildung der Copolyborane **K** genutzt wobei **Y** für zwei Halogenid-, zwei Alkoxy- oder eine Dioxyalkylenstruktur (mit 1 bis 3 C-Atomen) steht.

14. Verfahren zur Herstellung von Polyarylenboranen **K** nach Anspruch 13, wobei nicht nur jeweils eine der Arylenkomponenten **Ar¹** und/oder **Ar²** und/oder **Ar³** eingesetzt wird, sondern auch Arylenkomponenten aus mehreren Arylen-Copolymerkomponenten der drei Strukturtypen copolymerisiert mit einer und/oder mehreren Arylborverbindungen des Typs **G/G*** umgesetzt werden.

15. Verwendung der Polyarylborane des Typs **K**, 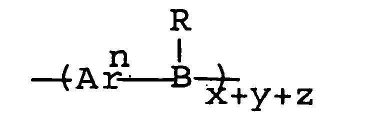 wobei Folgendes gilt:
**x,y** und **z** sind molare Teile von Komponenten und ergeben in Summe gleich 1, wobei zwei der Indizes **x,y** und **z** auch den Wert 0 haben können,
an den Enden sind Wasserstoff-Atome gebunden,
**Arⁿ** steht für die jeweilige Arylenkomponente, **-Ar¹-** und/oder **-Ar²-** und/oder **-Ar³-** im Copolymer,
dabei stehen **Ar¹** und **Ar²** für Komponenten mit einer bivalent konjugativ verbindenden ein- oder mehrkernigen, (homo-) aromatischen und/oder heteroaromatischen Arylenstruktur, wobei **Ar¹** für eine Komponente steht, deren π-Elektronendichte gleich oder größer als die von Benzol ist und **Ar²** für eine Komponente, die lochtransportfähig ist,
**Ar³** steht für eine Komponente mit einer beliebigen bivalent konjugativ verbindenden ein- oder mehrkernigen heteroaromatischen Arylenstruktur geringer n-Elektronendichte, die gleich oder kleiner als die des Benzols ist,
wobei die π-Elektronendichte von **Ar³** in jedem Fall kleiner als die von **Ar¹** ist,
und
**R** steht für einen Rest mit Arylstruktur, der je nach beabsichtigter Konjugation des Polyborans **K** einen heteroaromatischen und/oder einen (homo)-aromatischen Arylrest umfasst,
- der donorfrei ist, wobei eine Konjugation im Polyboran **K** durch Anlegen eines elektrischen Feldes ausgebildet werden kann, und/oder
- bei dem mindestens eine zusätzliche Donorfunktion substituiert ist (intrinsische Konjugationsausbildung) und/oder
- dessen Wasserstoffatome auch beliebig durch einen oder mehrere verzweigte oder unverzweigte Alkylreste oder Alkoxyreste
**R*,** substituiert sein können,
- als emittierende Schicht in verschiedenen Farben und weiss,
- als Elektronen transportierende Schicht,
- als Löcher blockierende Schicht und/oder
- mit einem Überschuß an Komponenten des Typs **Ar²** als lochtransportierende Schicht und/oder
in organischen halbleitenden Elementen wie Leuchtdioden und/oder Leuchtdiodendisplays, je nach ihrer Zusammensetzung,
sowie als maßgeschneidertes Transportmaterial in den Funktionsschichten organischer Solarzellen, organischer Photodetektoren und/oder organischer Feldeffekttransistoren.

16. Verwendung der Polyarylborane **K** gemäß Anspruch 15 als Blends von Einzelkomponentenpolymeren, also für den Fall, dass zwei der Verhältnisvariablen **x**, **y** und/oder **z** den Wert Null haben, in OLEDs als emittierende und/oder Elektronen transportierende Schicht.

17. Verwendung der polymeren Einzelkomponenten nach Anspruch 15 als Material für eine elektrolumineszierende Schicht und/oder organische Halbleiterschicht also Elektronen transportierend, Löcher blockierend oder Löcher transportierend.

18. Organisches Halbleiterbauelement mit
- einer aktiven Funktionsschicht, die Polyarylborane des Typs **K umfasst,** 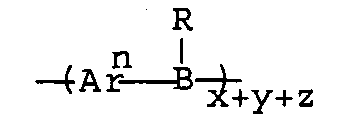
wobei Folgendes gilt:
**x,y** und **z** sind molare Teile von Komponenten und ergeben in Summe gleich 1, wobei zwei der Indizes **x,y** und **z** auch den Wert 0 haben können,
an den Enden sind Wasserstoff-Atome gebunden,
**Arⁿ** steht für die jeweilige Arylenkomponente, **-Ar¹-** und/oder **-Ar²-** und/oder **-Ar³-** im Copolymer,
dabei stehen **Ar¹** und **Ar²** für Komponenten mit einer bivalent konjugativ verbindenden ein- oder mehrkernigen, (homo-) aromatischen und/oder heteroaromatischen Arylenstruktur, wobei **Ar¹** für eine Komponente steht, deren n-Elektronendichte gleich oder größer als die von Benzol ist und **Ar³** für eine Komponente, die lochtransportfähig ist,
**Ar³ steht** für eine Komponente mit einer beliebigen bivalent konjugativ verbindenden ein- oder mehrkernigen heteroaromatischen Arylenstruktur geringer π-Elektronendichte, die gleich oder kleiner als die des Benzols ist,
wobei die π-Elektronendichte von **Ar³** in jedem Fall kleiner als die von **Ar¹** ist,
und
**R** steht für einen Rest mit Arylstruktur, der je nach beabsichtigter Konjugation des Polyborans **K** einen heteroaromatischen und/oder einen (homo)-aromatischen Arylrest umfasst,
- der donorfrei ist, wobei eine Konjugation im Polyboran **K** durch Anlegen eines elektrischen Feldes ausgebildet werden kann, und/oder
- bei dem mindestens eine zusätzliche Donorfunktion substituiert ist (intrinsische Konjugationsausbildung) und/oder
- dessen Wasserstoffatome auch beliebig durch einen oder mehrere verzweigte oder unverzweigte Alkylreste oder Alkoxyreste **R*,** substituiert sein können.

## Claims

1. Polyarylborane of the **K** type 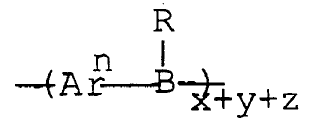 where:
**x, y** and **z** are molar parts of components and add up to 1, where two of the indices **x, y** and **z** may also have the value 0,
hydrogen atoms are bonded to the ends,
**Arⁿ** represents the particular arylene component, **-Ar¹-** and/or **-Ar²-** and/or **-Ar³-** in the copolymer, where the copolyarylboranes of the K type comprise an arylene component -Ar3-,
**Ar¹** and **Ar²** each represent components having a mono or polycyclic, (homo)aromatic and/or heteroaromatic arylene structure which is bonded in a bivalent, conjugating manner, where **Ar¹** represents a component whose π electron density is equal to or greater than that of benzene and **Ar²** represents a component which is capable of hole transport,
where **Ar³** is selected from the compounds of the **Ar³(a-m)** types shown in Table 3
**Table 3**
| | |
|---|---|
| 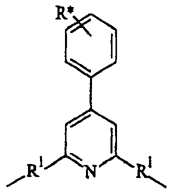 | |
| **Ar³ (a1)** 2,6-(diarylene)pyridinylenes | |
| 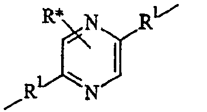 | 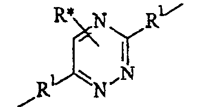 |
| **Ar³(b)** 2,5-(diarylene)pyrazinylenes | **Ar³(c)** 3,6-(diarylene)-1,2,4-triazinylenes |
| 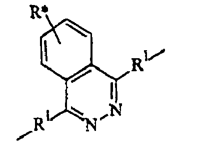 | 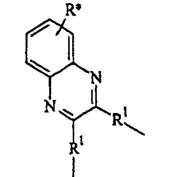 |
| **Ar³(d1)** 1,4-(diarylene)phthalazinylenes | **Ar³ (d2)** 2, 3- (diarylene)quinoxalinylenes |
| 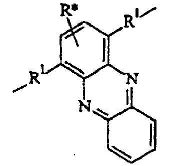 | 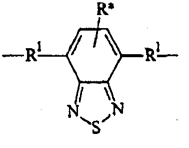 |
| **Ar³(d3)** 1,4-(diarylene)phenazinylenes | **Ar³ (e)** 1,4-(diarylene)benzo-thiadiazolylenes |
| 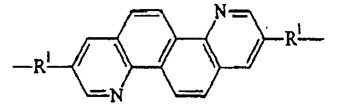 | 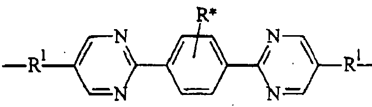 |
| **Ar³ (f)** 3,9-(diarylene)-1,7-diazachrysenylenes | **Ar³ (g1)** bis(2,2'-(diarylene)-pyrimidin-5,5'-ylene)arylenes |
| 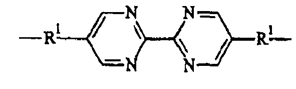 | 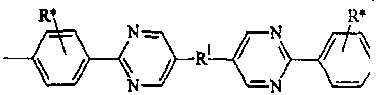 |
| **Ar³(g2)** 2,2'-pyrimidine-5,5'-(diarylene)-ylenes | **Ar³(h)** bis[5,5'-(diarylene)-pyrimidin-2,2'-ylenelarylenes |
| 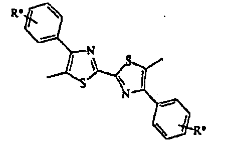 | 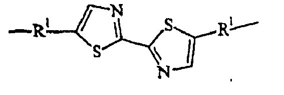 |
| **Ar³ (i1)** 2,2'-(5,5'-bis-1,3-thiazolylenes) | **Ar³ (i2)** 2,2'-(5,5'arylenebis-1,3-thiazolylenes) |
| 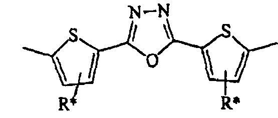 | 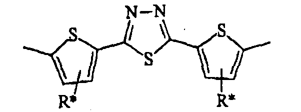 |
| **Ar³ (j1)** 5',5'-bis[2,5-(di-2',2'-thienyl)oxadiazolylenes] | **Ar³(j2)** 5',5'-bis[2,5-(di-2',2'-thienyl)thiadiazolylenes] |
| 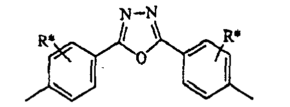 | 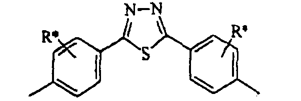 |
| **Ar³ (k1)** 4',4'-bis(2,5-diphenyl-oxadiazolylenes) | **Ar³ (k2)** 4',4'-bis(2,5-diphenyl-thiadiazolylenes) |
| 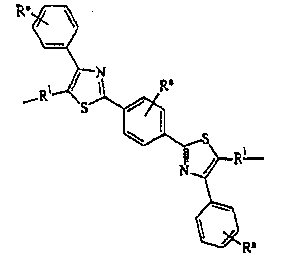 | 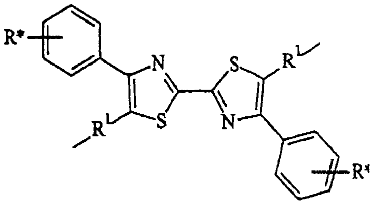 |
| **Ar³ (11)** 2,2'-(5,5'arylenebis-1,3-thiazolylene)arylenes | **Ar³(12)** 2,2'-(5,5'arylenebis-1,3-thiazolylenes) |
| 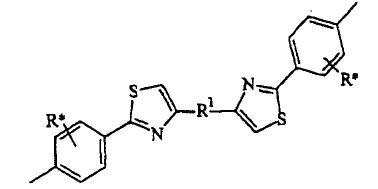 | 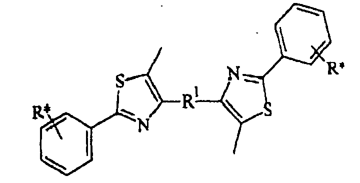 |
| **Ar³ (m1)** 4,4'-(2,2'arylenebis-1,3-thiazolylene)arylenes | **Ar³ (m2)** 4,4'-(5,5'arylenebis-1,3-thiazolylene)arylenes |
where the definition of the substituents **R¹** is the same as the substituent selection of the arylene component **Ar¹,**
where the arylene component Ar³ has a low π electron density which is equal to or less than that of benzene,
where the π electron density of **Ar³** is in each case less than that of **Ar¹,**
and
**R** represents a radical which has aryl structure and, depending on the intended conjugation of the polyborane **K**, includes a heteroaromatic and/or a (homo)aromatic aryl radical
- which is donor-free, where a conjugation in the polyborane **K** can be formed by application of an electrical field, and/or
- in which at least one additional donor function is substituted (intrinsic formation of conjugation) and/or
- its hydrogen atoms may also be substituted in any way by one or more branched or unbranched alkyl radicals or alkoxy radicals **R^{*}.**

2. Polyarylborane according to Claim 1, in which the arylene component(s) **Arⁿ** and/or the aryl substituents **R** are substituted at one or both ortho positions of the boron-carbon bonds.

3. Polyarylborane according to either of Claims 1 and 2, in which the arylene component(s) **Arⁿ** and/or the aryl substituents **R** are selected from the group of the following compounds: 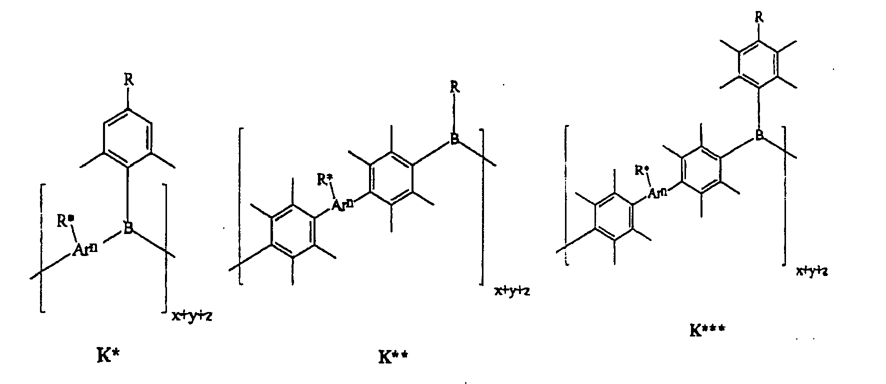 where the term aryl and/or arylene component is understood to mean a conjugated system of at least one cyclic substructure which, in the case of a plurality of cyclic substructures, may also be interrupted by vinylene units, where the cyclic substructures are of aromatic nature, i.e. are obtained from carbon or rings consisting of carbon and other elements, whose number of π electrons corresponds to (4n+2) (n is a parameter which can assume the values from 0 to 5) and their other σ bonds, apart from one in the case of the monovalent aryl structure or two in the case of the bivalent arylene structure, are bonded to hydrogen and/or any other substituents.

4. Polyarylborane according to Claim 2 or 3, in which at least one ortho substituent is a methyl substituent and/or a 3,6-durylene substituent is arranged between boron and an arylene component.

5. Polyarylborane according to one of Claims 1 to 4, where **Ar¹** has a 2,7-fluorenylene structure which may be substituted in the 9 position by unbranched and/or branched alkyl radicals.

6. Polyarylborane according to one of the preceding claims, where **Ar¹** is selected from the compounds of the **Ar¹(a-h)** types shown in Table 1
**Table 1**
| | | |
|---|---|---|
| 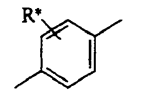 | 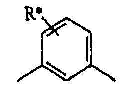 | 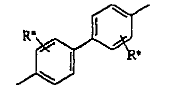 |
| **Ar¹(a1)** 1,4-phenylene | **Ar¹(a2)** 1,3-phenylene | **Ar¹(b1)**1,1'-(4,4'-biphenylene) |
| 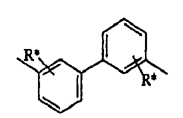 | 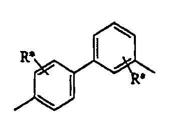 | 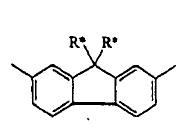 |
| **Ar¹(b2)** 1,1'-(3,3'-biphenylene) | **Ar¹ (b3)** 1,1'-(3,4'-biphenylene) | **Ar¹(c)** 2,7-fluorenylene |
| 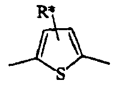 | 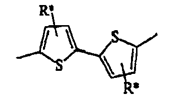 | 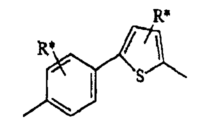 |
| **Ar¹ (d)** 2,5-thienylene | **Ar¹ (e)** 2,2'-(5,5'-bis-thienylene) | **Ar¹(f1)** 4',5-(2-phenylthienylene) |
| 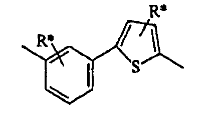 | 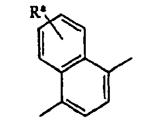 | 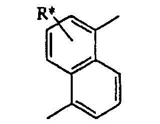 |
| **Ar¹(f2)** 3',5-(2-phenylthienylene) | **Ar¹(g1)** 1,4-naphthylene | **Ar¹ (g2)** 1,5-naphthylene |
| 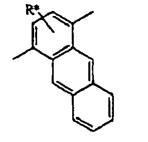 | 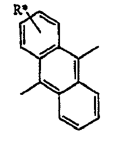 | 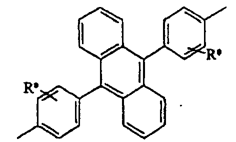 |
| **Ar¹ (h1)** 1,4-anthrylene | **Ar¹ (h2)** 9,10-anthrylene | **Ar¹ (h3)** 4',4'-bis-(9,10-diphenyl)-anthrylene |

7. Polyarylborane according to one of the preceding claims, where **Ar²** has perarylated amine substituents attached in a conjugating manner.

8. Polyarylborane according to one of the preceding claims, where **Ar²** is selected from the compounds of the **Ar²(a-f)** types shown in Table 2
**Table 2**
| |
|---|
| 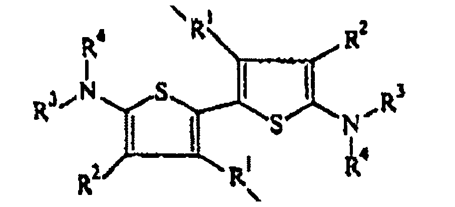 |
| **Ar² (a)** [bis(2,2'-diarylamino-3,3'-diaryl-5,5'-thien)]-4,4'-ylene |
| 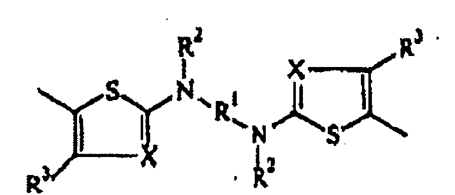 |
| **Ar² (b)** [N,N'-bis(thien-2-yl)- or N,N'-bis(1,3-thiazol-2-yl)-N,N'-diaryl-diaminoarylene]-5,5'-ylene |
| 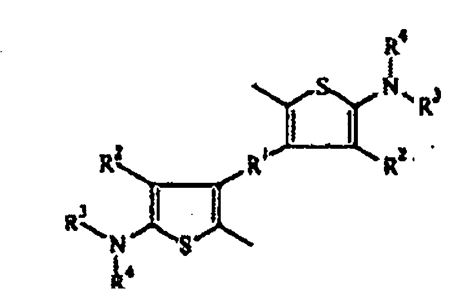 |
| **Ar² (c)** [bis(2,2'-diarylamino)-3,3'-diaryl-4,4'-thienyl)-arylene]-5,5'-ylene |
| 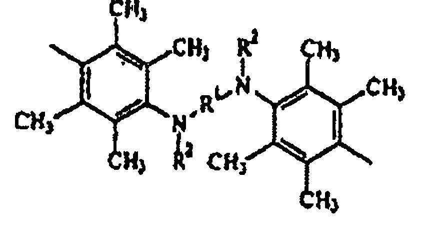 |
| **Ar² (d)** [N,N'-bis(3-duryl)-N,N'-diaryl-diaminoarylene]-6,6'-ylene |
| 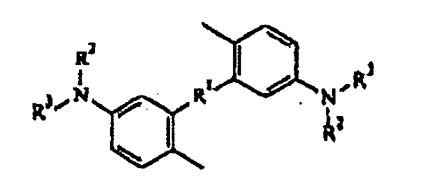 |
| **Ar² (e)** bis[(5,5'-diarylamino-phenyl)-arylene]-2,2'-ylene |
| 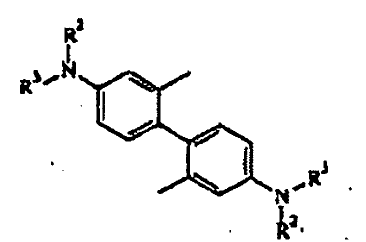 |
| **Ar² (f)** bis(4,4'-diarylamino-phenyl)-2,2'-ylene |
where the substituents **R², R³** and **R⁴** are aryl substituents, but the definitions of the substituents **Rⁿ** with the same index n are identical and/or the definition of the substituents **R¹** is the same as the substituent selection for the arylene component **Ar¹;** for **Ar²(b), x** is also **N** or **C-R⁴.**

9. Polyarylborane according to one of the preceding claims, where the substituents **R², R³ and R⁴** of **Ar²** are selected from the group of the following compounds: phenyl, 1-naphthyl and 2-naphthyl.

10. Polyarylborane according to one of the preceding claims, where **R** is selected from the compounds of the types shown in Table 4
- [**R(a1-a5)**] donor free,
- **[R(b-e)]** in which at least one donor function is substituted and/or
- **R(f)**
**Table 4:**
| | | |
|---|---|---|
| 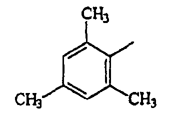 | 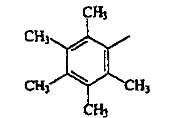 | 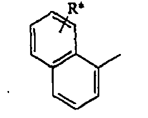 |
| **R(a1)** mesityl | **R(a2)** pentamethylphenyl | **R(a3)** 1-naphthyl |
| 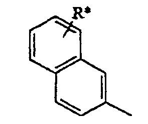 | 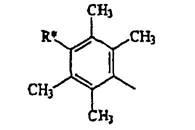 | |
| **R(a4)** 2-naphthyl | **R(a5)** 3-alkyl/alkoxy dur-6-yl | |
| 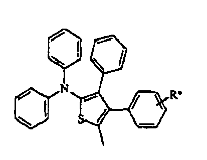 | 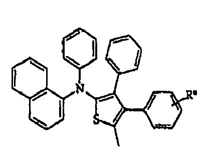 | 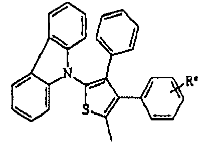 |
| **R(b1)** 2-diphenylamino 3,4-diphenylthien-5-yl | **R(b2)** 2-[(1-naphthyl)-phenylamino] 3,4-diphenylthien-5-yl | **R(b3)** 2-(N-carbazoyl) 3,4-dipheny]thien-5-yl |
| 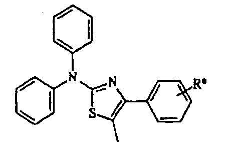 | 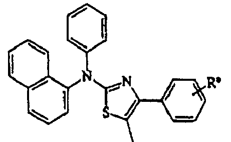 | |
| **R(c1)** 2-diphenylamino 3,4-diphenyl-1,3-thiazol-5-yl | **R(c2)** 2-[(1-naphthyl)-phenylamino]-3,4 diphenyl-1,3 thiazol-5-yl | |
| 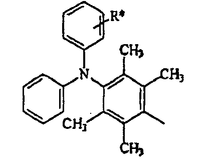 | 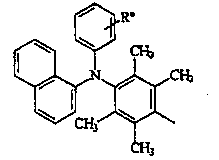 | 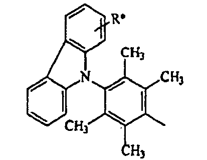 |
| **R(d1)** 3-diphenylamino-dur-6-yl | **R(d2)** 3-[(1-naphthyl)-phenylamino]dur-6-yl | **R(d3)** 3-(N-carbazoyl)-dur-6-yl |
| 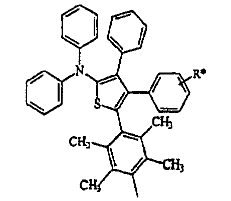 | 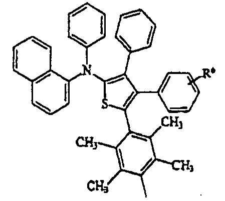 | 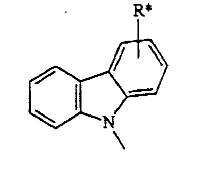 |
| **R(e1)** 2-diphenylamino-3,4- diphenyl-5-(3-dur-6-yl)thiophene | **R(e2)** 2-[(1-naphthyl) phenylamino]-3,4 diphenyl-5-(3-dur-6-yl)thiophene | **R(f)** N-carbazoyl |

11. Polyarylborane according to one of the preceding claims, whose solubility in organic solvents is improved by any additional arrangement of one or more unbranched and/or branched alkyl substituents and/or alkoxy substituents **R^{*}.**

12. Polyarylborane according to one of the preceding claims, where one or more of the alkyl and/or alkoxy radicals have from 1 to 10 carbon atoms.

13. Process for preparing the polyarylboranes of the **K** type according to one of the preceding claims by the general preparation scheme.
Reaction scheme: 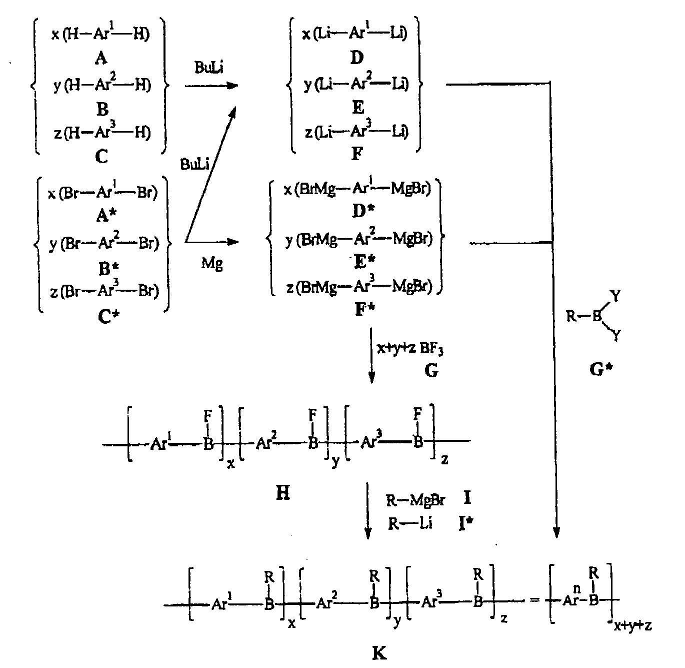 where the starting materials are the arenes **A** to **C** or the bromine-substituted arylene structures **A^{*}** to **C^{*},** these are subjected to umpolung either by a Grignard reaction (**D^{*}** to **F^{*}**) or by lithiation (**D** to **F**), then one of the reaction paths **G** or **G^{*}** is utilized to form the copolyboranes **K** where **Y** represents two halide, two alkoxy or one dioxyalkylene structure (having from 1 to 3 carbon atoms).

14. Process for preparing polyaryleneboranes **K** according to Claim 13, where not just one of the arylene components **Ar¹** and/or **Ar²** and/or **Ar³** is used in each case, but rather arylene components composed of a plurality of arylene copolymer components of the three structural types are also copolymerized with one and/or more arylboron compounds of the **G/G^{*}** type.

15. Use of the polyarylboranes of the **K** type 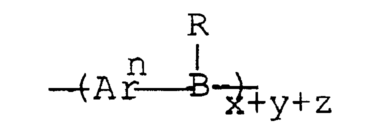 where:
**x, y** and **z** are molar parts of components and add up to 1, where two of the indices **x**, **y** and **z** may also have the value 0,
hydrogen atoms are bonded to the ends,
**Arⁿ** represents the particular arylene component, **-Ar¹-** and/or **-Ar²-** and/or **-Ar³-** in the copolymer,
**Ar¹** and **Ar²** each represent components having a mono or polycyclic, (homo)aromatic and/or heteroaromatic arylene structure which is bonded in a bivalent, conjugating manner, where **Ar¹** represents a component whose π electron density is equal to or greater than that of benzene and **Ar²** represents a component which is capable of hole transport,
**Ar³** represents a component having any mono- or polynuclear heteroaromatic arylene structure which is bonded in any bivalent, conjugating manner and has low π electron density which is equal to or less than that of benzene,
where the π electron density of **Ar³** is in each case less than that of **Ar¹,**
and
**R** represents a radical which has aryl structure and, depending on the intended conjugation of the polyborane **K**, includes a heteroaromatic and/or a (homo)aromatic aryl radical
- which is donor-free, where a conjugation in the polyborane **K** can be formed by application of an electrical field, and/or
- in which at least one additional donor function is substituted (intrinsic formation of conjugation) and/or
- its hydrogen atoms may also be substituted in any way by one or more branched or unbranched alkyl radicals or alkoxy radicals **R^{*},**
in organic semiconducting elements such as light-emitting diodes and/or light-emitting diode displays, according to their composition,
- as an emitting layer in various colors and white,
- as an electron transporting layer,
- as a hole blocking layer and/or
- with an excess of components of the **Ar²** type as a hole transporting layer and/or
also as a tailored transport material in the functional layers of organic solar cells, organic photodetectors and/or organic field-effect transistors.

16. Use of the polyarylboranes **K** according to Claim 15 as blends of single component polymers, i.e., in the case that two of the relative variables **x, y** and/or **z** have the value zero, in OLEDs as emitting and/or electron transporting layers.

17. Use of the polymeric single components according to Claim 15 as a material for an electroluminescent layer and/or organic semiconductor layer, i.e. electron transporting, hole blocking or hole transporting.

18. Organic semiconducting element having 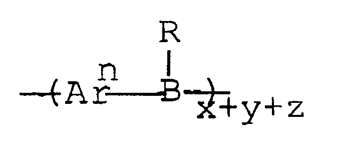 where:
**x, y** and **z** are molar parts of components and add up to 1, where two of the indices **x, y** and **z** may also have the value 0,
hydrogen atoms are bonded to the ends,
**Arⁿ** represents the particular arylene component, **-Ar¹-** and/or **-Ar²-** and/or **-Ar³-** in the copolymer,
**Ar¹** and **Ar²** each represent components having a mono or polycyclic, (homo)aromatic and/or heteroaromatic arylene structure which is bonded in a bivalent, conjugating manner, where **Ar¹** represents a component whose π electron density is equal to or greater than that of benzene and **Ar²** represents a component which is capable of hole transport,
**Ar³** represents a component having any mono- or polynuclear heteroaromatic arylene structure which is bonded in any bivalent, conjugating manner and has low π electron density which is equal to or less than that of benzene,
where the π electron density of **Ar³** is in each case less than that of **Ar¹,**
and
**R** represents a radical which has aryl structure and, depending on the intended conjugation of the polyborane **K**, includes a heteroaromatic and/or a (homo)aromatic aryl radical
- which is donor-free, where a conjugation in the polyborane **K** can be formed by application of an electrical field, and/or
- in which at least one additional donor function is substituted (intrinsic formation of conjugation) and/or
- its hydrogen atoms may also be substituted in any way by one or more branched or unbranched alkyl radicals or alkoxy radicals **R^{*}.**

## Revendications

1. Polyarylboranes du type **K**, 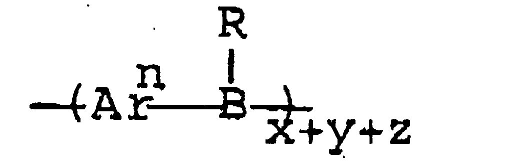 où
**x, y** et **z** sont les parties molaires des composants et leur somme est égale à 1, deux des indices **x**, **y** et **z** pouvant également avoir la valeur 0,
des atomes d'hydrogène sont fixés aux extrémités,
**Arⁿ** représente le composant arylène respectif, **-Ar¹-** et/ou **-Ar²-** et/ou **-Ar³-** dans le copolymère, les copolyarylboranes du type **K** contenant un composant arylène **-Ar3-,**
**Ar¹** et **Ar²** représentent des composants ayant une structure arylène (homo-)aromatique et/ou hétéroaromatique divalente mono- ou polynucléaire, à liaison par conjugaison, **Ar¹** représentant un composant dont la densité d'électrons n est égale ou supérieure à celle du benzène et **Ar²** représentant un composant qui est apte au transport de trous,
**Ar³** étant choisi parmi les composés des types **Ar³ (a-m)** indiqués dans le tableau 3,
**Tableau 3**
| | |
|---|---|
| 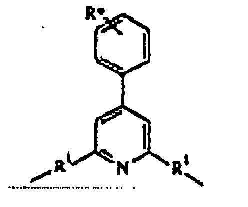 | |
| **Ar³ (a1)** 2,6-(diarylène)-pyridinylène | |
| 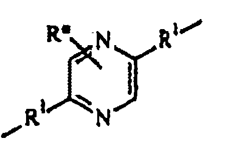 | 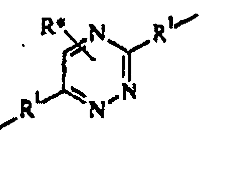 |
| **Ar³ (b)** 2,5-(diarylène)-pyrazinylène | **Ar³ (c)** 3,6-(diarylène)-1,2,4-triazinylène |
| 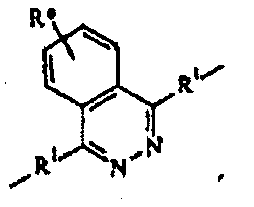 | 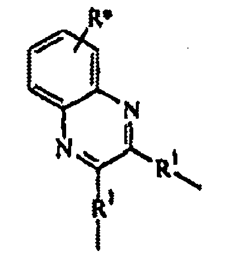 |
| **Ar³ (d1)** 1,4-(diarylène)-phtalazinylène | **Ar³ (d2)** 2,3-(diarylène)-quinoxalinylène |
| 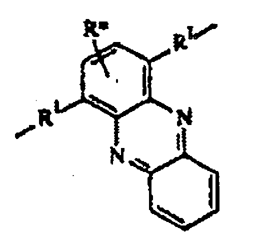 | 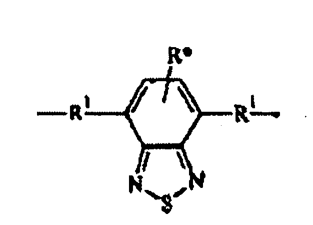 |
| **Ar³ (d3)** 1,4-(diarylène)-phénazinylène | **Ar³ (e)** 1,4-(diarylène)-benzothiadiazolylène |
| 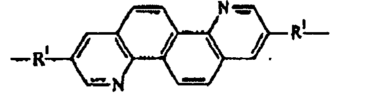 | 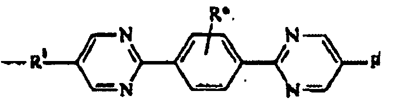 |
| **Ar³ (f)** 3,9-(diarylène)-1,7-diazachrysénylène | **Ar³ (g1)** bis(2,2'-(diarylène)-pyrimidin-5,5'-ylène)-arylène |
| 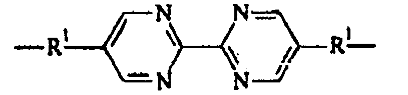 | 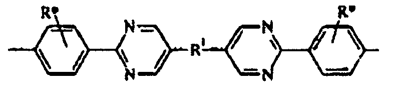 |
| **Ar³ (g2)** 2,2'-pyrimidine-5,5'-(diarylène)-ylène | **Ar³ (h)** bis[5,5'-(diarylène)-pyrimidin-2,2'-ylène]-arylène |
| 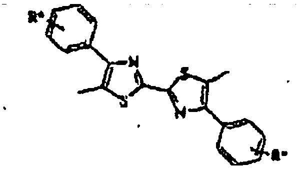 | 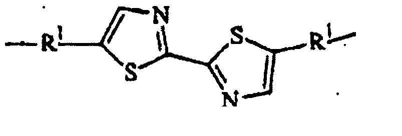 |
| | |
| **Ar³ (i1)** 2,2'-(5,5'-bis-1,3- thiazolylène) | **Ar³ (i2)** 2,2'-(5,5'-arylène-bis-1,3-thiazolylène) |
| 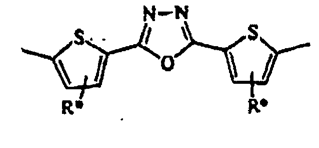 | 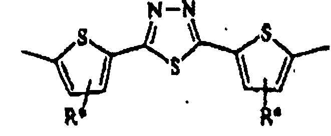 |
| **Ar³ (j1)** 5',5'-bis[2,5-(di-2',2'-thiényl)-oxadiazolylène] | **Ar³ (j2)** 5',5'-bis[2,5-(di-2',2'-thiényl)-thiadiazolylène] |
| 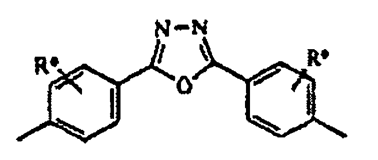 | 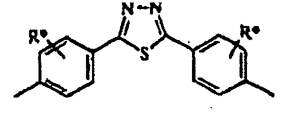 |
| **Ar³ (k1)** 4',4'-bis(2,5-(diphényl-oxadiazolylène) | **Ar³ (k2)** 4',4'-bis(2,5-(diphényl-thiadiazolylène) |
| 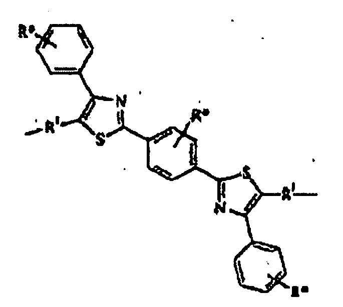 | 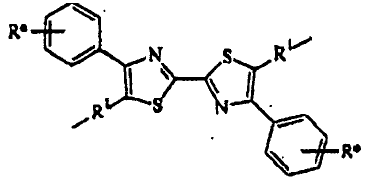 |
| | |
| **Ar³ (11)** 2,2'-(5,5'-arylène-bis-1,3-thiazolylène)-arylène | **Ar³ (l2)** 2,2'-(5,5'-arylène-bis-1,3-thiazolvlène) |
| 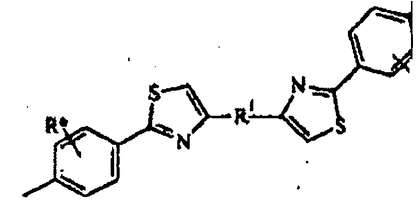 | 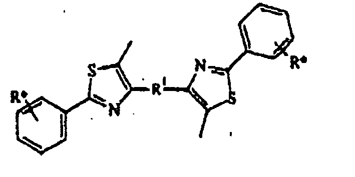 |
| **Ar³ (m1)** 4,4'-(2,2'-arylène-bis-1,3-thiazolylène)-arylène | **Ar³ (m2)** 4,4'-(5,5'-ylène-bis-1,3-thiazolylène)-arylène |
la signification des substituants **R¹** est en ce cas équivalente au choix des substituants pour le composant arylène **Ar¹,**
le composant arylène **Ar³** ayant une faible densité d'électrons n, qui est égale ou inférieure à celle du benzène
la densité d'électrons n de **Ar³** étant dans chaque cas inférieure à celle de **Ar¹,**
et
**R** représente un radical à structure aryle, qui selon la conjugaison envisagée du polyborane **K** comprend un radical aryle hétéroaromatique et/ou un radical aryle (homo)-aromatique,
- qui est exempt de donneur, une conjugaison dans le polyborane **K** pouvant être formée par application d'un champ électrique, et/ou
- dans lequel au moins une fonction de donneur supplémentaire est substituée (formation de conjugaison intrinsèque) et/ou
- dont les atomes d'hydrogène peuvent être remplacés de façon quelconque par un ou plusieurs radicaux alkyle ou radicaux alcoxy **R*** ramifiés ou non ramifiés.

2. Polyarylborane selon la revendication 1, dans lequel le(s) composant(s) arylène **Arⁿ** et/ou les substituants aryle **R** comportent substituée(s) une position ortho ou les deux positions ortho des liaisons bore-carbone.

3. Polyarylborane selon la revendication 1 ou 2, dans lequel le(s) composant(s) arylène **Arⁿ** et/ou les substituants aryle **R** sont choisis dans le groupe des composés suivants : 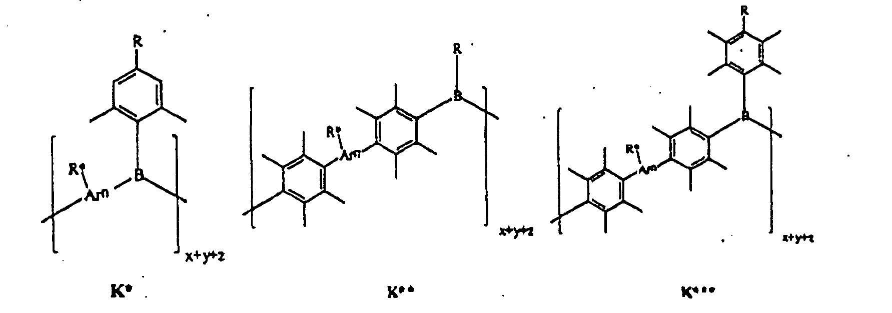 en entendant par le terme "composant aryle et/ou arylène" un système conjugué d'au moins une structure partielle cyclique, dans le cas de plusieurs structures cycliques celles-ci pouvant également être interrompues par des groupes vinylène, les structures partielles cycliques étant de nature aromatique, c'est-à-dire étant engendrées à partir de cycles consistant en carbone ou en carbone et en autres éléments dont le nombre d'électrons π correspond à (4n+2) (n est un paramètre qui peut prendre les valeurs 0 à 5) et dont les autres liaisons σ, sauf une, dans le cas de la structure aryle monovalente, ou deux, dans le cas de la structure arylène divalente, sont liées à un atome d'hydrogène et/ou à d'autres substituants quelconques.

4. Polyarylborane selon la revendication 2 ou 3, dans lequel au moins un substituant en position ortho est un substituant méthyle et/ou entre l'atome de bore et un composant arylène est disposé un substituant 3,6-durylène.

5. Polyarylboranes selon l'une quelconque des revendications 1 à 4, dans lesquels **Ar¹** a une structure 2,7-fluorénylène qui peut être substituée en position 9 par des radicaux aryle ramifiés et/ou non ramifiés.

6. Polyarylboranes selon l'une quelconque des revendications précédentes, dans lesquels **Ar¹** est choisi parmi les composés des types **Ar¹ (a-h)** indiqués dans le tableau 1
**Tableau 1 :**
| | | |
|---|---|---|
| 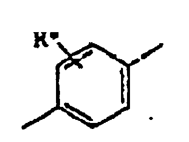 | 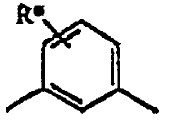 | 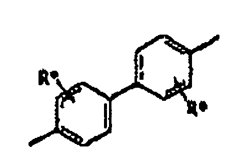 |
| **Ar¹ (a1)** 1,4-phénylène | **Ar¹ (a2)** 1,3-phénylène | **Ar¹ (b1)** 1,1'-(4,4'-biphénylène) |
| 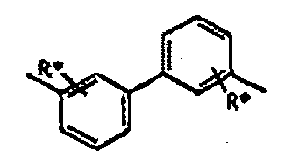 | 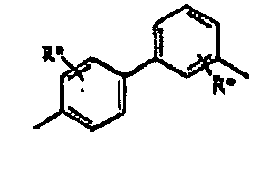 | 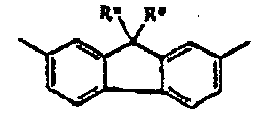 |
| 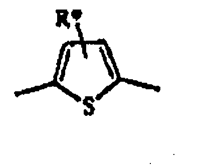 **Ar¹ (b2)** 1,1'-(3,3'-biphénylène) | 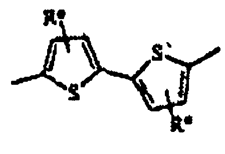 **Ar¹ (b3)** 1,1'-(3,4'-biphénylène) | 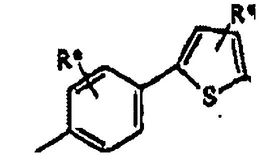 **Ar¹ (c)** 2,7-fluorénylène |
| 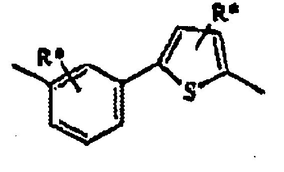 **Ar¹ (d)** 2,5-thiénylène | 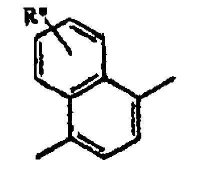 **Ar¹ (e)** 2,2'-(5,5'-bis-thiénylène) | 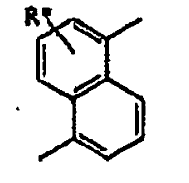 **Ar¹ (f1)** 4',5-(2-phényl-thiénylène) |
| **Ar¹ (f2)** 3',5-(2-phénylthiénylène) | **Ar¹ (g1)** 1,4-naphtylène | **Ar¹ (g2)** 1,5-naphtylène |
| 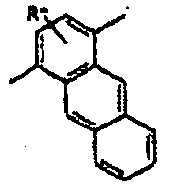 | 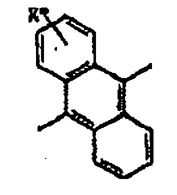 | 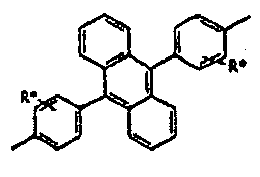 |
| **Ar¹ (h1)** 1,4-anthrylène | **Ar¹ (h2)** 9,10-anthrylène | **Ar¹ (h3)** 4',4'-bis(9,10-diphényl)-anthrylène |

7. Polyarylboranes selon l'une quelconque des revendications précédentes, dans lesquels **Ar²** est doté de substituants amino perarylés liés par conjugaison.

8. Polyarylboranes selon l'une quelconque des revendications précédentes, dans lesquels **Ar²** est choisi parmi les composés des types **Ar² (a-f)** indiqués dans le tableau 2,
**Tableau 2 :**
| |
|---|
| 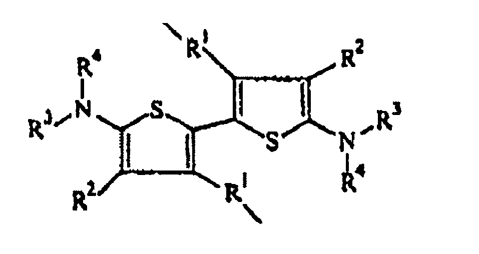 |
| **Ar² (a)** [bis(2,2'-diarylamino-3,3'-diaryl-5,5'-thién)]-4,4'-ylène |
| 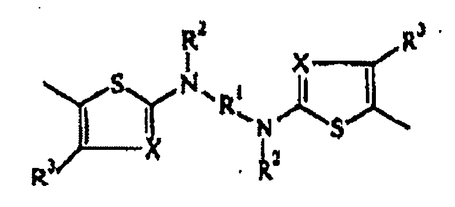 |
| **Ar² (b)** [N,N'-bis(thién-2-yl)- ou N,N'-bis(1,3-thiazol-2-yl)-N,N'-diaryl-diaminoarylène]-5,5'-ylène |
| 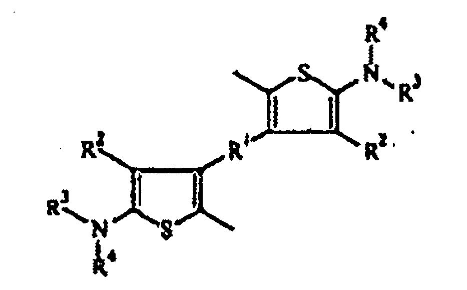 |
| **Ar² (c)** [bis(2,2'-diarylamino)-3,3'-diaryl-4,4'-thiényl)-arylén]-5,5'-ylène |
| 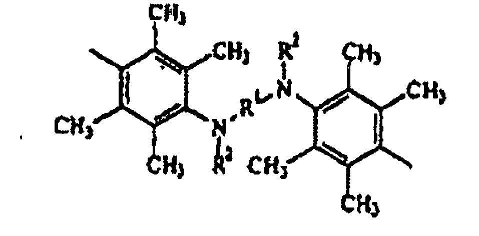 |
| **Ar² (d)** [N,N'-bis(3-duryl)-N,N'-diaryl-diaminoarylén]-6,6'-ylène |
| 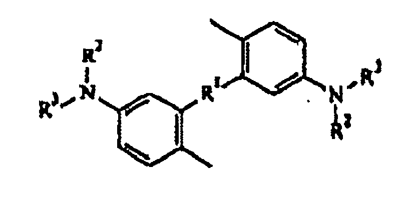 |
| **Ar² (e)** bis[(5,5'-diarylamino-phényl)-arylén]-2,2'-ylène |
| 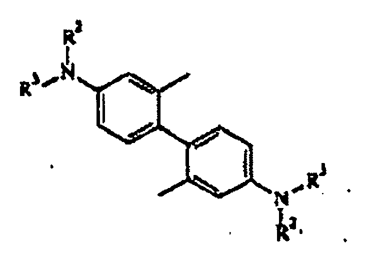 |
| **Ar² (f)** bis(4,4'-diarylamino-phényl)-2,2'-ylène |
les substituants **R², R³** et **R⁴** étant des substituants aryle, les significations des substituants **Rⁿ** avec le même indice **n** étant toutefois identiques et/ou les significations des substituants **R¹** étant identiques au choix des substituants pour le composant arylène **Ar¹,** pour **Ar² (b),** il s'applique en outre que X représente **N** ou **C-R⁴.**

9. Polyarylboranes selon l'une quelconque des revendications précédentes, dans lesquels les substituants **R², R³** et **R⁴** de **Ar²** sont choisis dans l'ensemble des groupes suivants : phényle, 1-naphtyle et 2-naphtyle.

10. Polyarylboranes selon l'une quelconque des revendications précédentes, dans lesquels **R** est choisi parmi les composés des types
- **[R(a1-a5)]** exempts de donneurs,
- **[R(b-e)]** dans lesquels au moins une fonction de donneur est substituée et/ou
- **R(f)**
indiqués dans le tableau 4
**Tableau 4 :**
| | | |
|---|---|---|
| 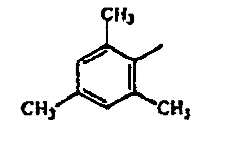 | 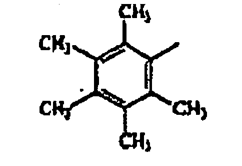 | 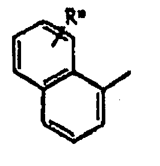 |
| **R(a1)** mésityle | **R(a2)** pentaméthylphényle | **R(a3)** 1-naphtyle |
| 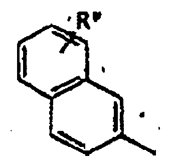 | 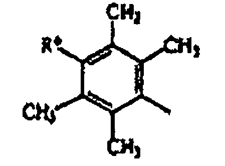 | |
| **R(a4)** 2-naphtyle | **R(a5)** 3-alkyl/alcoxy-dur-6-yle | |
| 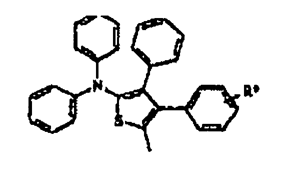 | 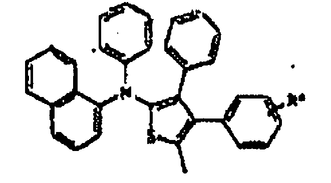 | 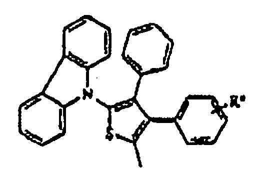 |
| **R(b1)** 2-diphénylamino-3,4-diphényl-thién-5-yle | **R(b2)** 2-[(1-naphtyl)-phényl-amino]-3,4-diphénylthién-5-yle | **R(b3)** 2-(N-carbazoyl)-3,4-diphénylthién-5-yle |
| 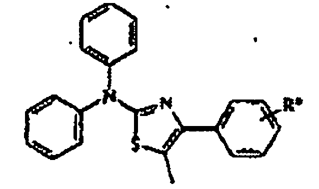 | 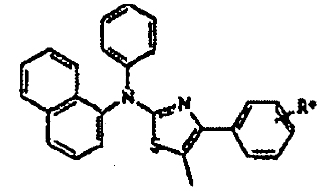 | |
| **R(c1)** 2-diphénylamino-3,4-diphényl-1,3-thiazol-5-yle | **R(c2)** 2-[(1-naphtyl)-phénylamino]-3,4-diphényl-1,3-thiazol-5-yle | |
| 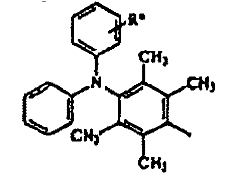 | 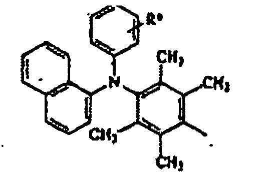 | 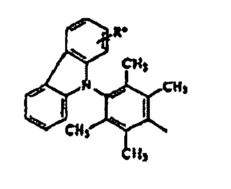 |
| **R(d1)** 3-diphénylamino-dur-6-yle | **R(d2)** 3-[(1-naphtyl)-phényl-amino]-dur-6-yle | **R(d3)** 3-(N-carbazoyl)-dur-6-yle |
| 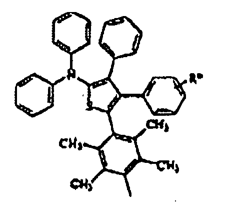 | 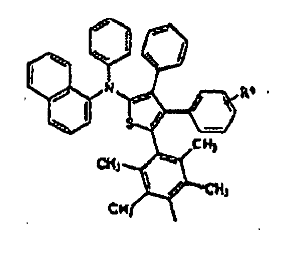 | 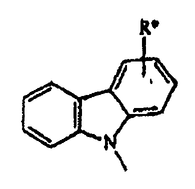 |
| **R(e1)** 2-diphénylamino-3,4-diphényl-5-(3-dur-6-yl)-thiophène | **R(e2)** 2-[(1-naphtyl)-phényl-amino]-3,4-diphényl-5-(3-dur-6-yl)-thiophène | **R(f)** N-carbazoyle |

11. Polyarylboranes selon l'une quelconque des revendications précédentes, dont la solubilité dans les solvants organiques est améliorée par disposition supplémentaire quelconque d'un ou plusieurs substituants alkyle et/ou substituants alcoxy **R*** ramifiés et/ou non ramifiés.

12. Polyarylboranes selon l'une quelconque des revendications précédentes, dans lesquels un ou plusieurs des radicaux alkyle et/ou alcoxy a/ont de 1 à 10 atomes de carbone.

13. Procédé pour la préparation des polyarylboranes du type **K** selon l'une quelconque des revendications précédentes, conformément au schéma de préparation général,
Schéma de réactions 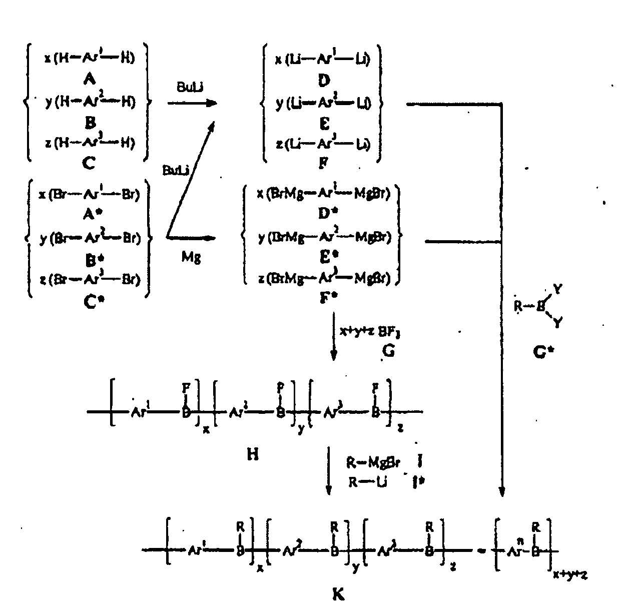 dans lequel on part des arènes **A** à **C** ou des structures arylène substituées par le brome **A*** à **C*,** on en inverse les pôles soit par une réaction de Grignard (**D*** à **F***), soit par lithiation (**D** à **F**), puis on utilise l'une des voies de réaction **G** ou **G*** pour la formation des copolyboranes **K**, **Y** représentant deux structures halogénure, deux structures alcoxy ou une structure dioxyalkylène (ayant de 1 à 3 atomes de carbone).

14. Procédé pour la préparation de polyarylèneboranes **K** selon la revendication 13, dans lequel on utilise non seulement chaque fois l'un des composants arylène **Ar¹** et/ou **Ar²** et/ou **Ar³,** mais on fait également réagir des composants arylène à base de plusieurs composants copolymères d'arylène des trois types structuraux copolymérisés avec un et/ou plusieurs composés arylborane du type **G/G*.**

15. Utilisation des polyarylboranes du type **K**, 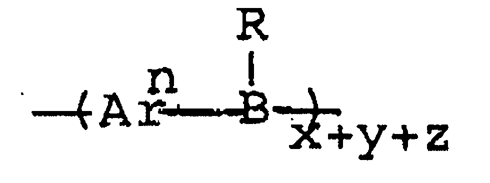 où
**x, y** et **z** sont les parties molaires des composants et leur somme est égale à 1, deux des indices **x, y** et **z** pouvant également avoir la valeur 0,
des atomes d'hydrogène sont fixés aux extrémités
**Arⁿ** représente le composant arylène respectif, **-Ar¹-** et/ou **-Ar²-** et/ou **-Ar³-** dans le copolymère,
**Ar¹** et **Ar²** représentent des composants ayant une structure arylène (homo-)aromatique et/ou hétéroaromatique divalente mono- ou polynucléaire, à liaison par conjugaison, **Ar¹** représentant un composant dont la densité d'électrons n est égale ou supérieure à celle du benzène et **Ar²** représentant un composant qui est apte au transport de trous,
**Ar³** représente un composant ayant une structure arylène hétéroaromatique mono- ou polynucléaire divalente quelconque se liant par conjugaison, à faible densité d'électrons n, qui est égale ou inférieure à celle du benzène,
la densité d'électrons n de **Ar³** étant dans chaque cas inférieure à celle de **Ar¹,** et
**R** représente un radical à structure aryle, qui selon la conjugaison envisagée du polyborane **K** comprend un radical aryle hétéroaromatique et/ou un radical aryle (homo)-aromatique,
- qui est exempt de donneur, une conjugaison dans le polyborane **K** pouvant être formée par application d'un champ électrique, et/ou
- dans lequel au moins une fonction de donneur supplémentaire est substituée (formation de conjugaison intrinsèque) et/ou
- dont les atomes d'hydrogène peuvent être remplacés de façon quelconque par un ou plusieurs radicaux alkyle ou radicaux alcoxy **R*** ramifiés ou non ramifiés,
dans des éléments semi-conducteurs organiques tels que des diodes luminescentes et/ou des afficheurs à diodes luminescentes, selon leur composition,
- en tant que couche émettrice en diverses couleurs et en blanc,
- en tant que couche transporteuse d'électrons,
- en tant que couche de piégeage de trous et/ou
- avec un excès de composants du type **Ar²,** en tant que couche transporteuse de trous et/ou
ainsi qu'en tant que matériau de transport adapté dans les couches fonctionnelles de cellules solaires organiques, de photodétecteurs organiques et/ou de transistors à effet de champ organiques.

16. Utilisation des polyarylboranes **K** selon la revendication 15, en tant qu'alliages de polymères composants individuels, à savoir dans le cas où deux des variables de rapport **x, y** et/ou **z** ont la valeur zéro, dans des OLED (diodes luminescentes organiques) en tant que couche émettrice et/ou transporteuse d'électrons.

17. Utilisation des composants individuels polymères selon la revendication 15, en tant que matériau pour une couche électroluminescente et/ou une couche de semi-conducteur organique, à savoir transporteuse d'électrons, de piégeage de trous ou transporteuse de trous.

18. Élément semi-conducteur organique comportant
- une couche fonctionnelle active qui comprend des polyarylboranes du type **K**, 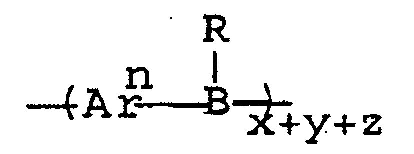
où :
**x, y** et **z** sont les parties molaires des composants et leur somme est égale à 1, deux des indices **x, y** et **z** pouvant également avoir la valeur 0,
des atomes d'hydrogène sont fixés aux extrémités,
**Arⁿ** représente le composant arylène respectif, **-Ar¹-** et/ou **-Ar²-** et/ou **-Ar³-** dans le copolymère,
**Ar¹** et **Ar²** représentent des composants ayant une structure arylène (homo-)aromatique et/ou hétéroaromatique divalente mono- ou polynucléaire, à liaison par conjugaison, **Ar¹** représentant un composant dont la densité d'électrons n est égale ou supérieure à celle du benzène et **Ar²** représentant un composant qui est apte au transport de trous,
**Ar³** représente un composant ayant une structure arylène hétéroaromatique mono- ou polynucléaire divalente quelconque se liant par conjugaison, à faible densité d'électrons π, qui est égale ou inférieure à celle du benzène
la densité d'électrons π de **Ar³** étant dans chaque cas inférieure à celle de **Ar¹,**
et
**R** représente un radical à structure aryle, qui selon la conjugaison envisagée du polyborane **K** comprend un radical aryle hétéroaromatique et/ou un radical aryle (homo)-aromatique,
- qui est exempt de donneur, une conjugaison dans le polyborane **K** pouvant être formée par application d'un champ électrique, et/ou
- dans lequel au moins une fonction de donneur supplémentaire est substituée (formation de conjugaison intrinsèque) et/ou
- dont les atomes d'hydrogène peuvent être remplacés de façon quelconque par un ou plusieurs radicaux alkyle ou radicaux alcoxy **R*** ramifiés ou non ramifiés.
